(19) Europäisches Patentamt
European Patent Office
Office européen des brevets

(11) **EP 2 702 360 B1**

(12) **EUROPÄISCHE PATENTSCHRIFT**

(45) Veröffentlichungstag und Bekanntmachung des Hinweises auf die Patenterteilung:
**12.08.2015 Patentblatt 2015/33**

(21) Anmeldenummer: **12718126.1**

(22) Anmeldetag: **16.04.2012**

(51) Int Cl.:
***G01D 3/028*** (2006.01)

(86) Internationale Anmeldenummer:
**PCT/EP2012/056947**

(87) Internationale Veröffentlichungsnummer:
**WO 2012/146505 (01.11.2012 Gazette 2012/44)**

(54) **SENSORANORDNUNG UND VERFAHREN**

SENSOR ASSEMBLY AND METHOD

ENSEMBLE DE CAPTEURS ET PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.04.2011 DE 102011017640**

(43) Veröffentlichungstag der Anmeldung:
**05.03.2014 Patentblatt 2014/10**

(73) Patentinhaber: **Fraunhofer Gesellschaft zur Förderung der angewandten Forschung E.V. 80686 München (DE)**

(72) Erfinder:
• **HERZER, Elmar 91052 Erlangen (DE)**
• **SCHLAG, Ulrich 91056 Erlangen (DE)**
• **SAUERER, Josef 91074 Herzogenaurach (DE)**

(74) Vertreter: **Zimmermann, Tankred Klaus Schoppe, Zimmermann, Stöckeler Zinkler, Schenk & Partner mbB Patentanwälte Radlkoferstrasse 2 81373 München (DE)**

(56) Entgegenhaltungen:
**EP-A1- 0 464 391     EP-A1- 0 525 235
DE-B4-102004 010 362**

**Beschreibung**

Technisches Gebiet

Ausführungsbeispiele der vorliegenden Erfindung schaffen eine Sensoranordnung, wie sie beispielsweise in Verbindung mit Hall-Sensoren verwendet werden kann. Weitere Ausführungsbeispiele schaffen ein Verfahren, welches beispielsweise in Verbindung mit Hall-Sensoren verwendet werden kann.

Hintergrund der Erfindung

Prinzipiell werden der Offset eines Sensors und der eines nachfolgenden Verstärkers getrennt vom Nutzsignal ermittelt oder kompensiert, da sonst ein unbekannter Wert der Messung überlagert ist, der im besten Falle konstant, aber meistens von der Temperatur abhängig ist. Bei der Messung von sehr kleinen Signalen kann das Offsetsignal durchaus in Größenordnungen über dem Nutzsignal liegen. Damit bei der Weiterverarbeitung bestehende stochastische Störsignale wenig Einfluss auf die Messung haben und im Vergleich zum Nutzsignal klein bleiben, wird das Nutzsignal unmittelbar nach dem Sensor hoch verstärkt. Ist das Offsetsignal aber zu groß, dann wird der Verstärker von diesem Offsetsignal schon in die Begrenzung getrieben und das Nutzsignal kann nicht mehr an die nachfolgende Verarbeitungskette weitergelangen. Im Folgenden sollen einige Konzepte zur Offsetkompensation vorgestellt werden.

1. Offsetkompensation durch Addition/Subtraktion eines digital geregelten Signals nach dem Verstärker

Es gibt Schaltungen, die verstärken das Signal zunächst ein wenig, um dann eine Korrekturspannung abzuziehen. Danach folgt eine weitere Verstärkerstufe. Das Sensorsignal wird vor der Verstärkung nicht verschlechtert. Durch die vom Offset bedingte Übersteuerung sind aber nur kleine Verstärkungen möglich.

Ein etwas besseres Verfahren zeigt die DE 10 2004 010 362 B4 oder die DE 10 2009 006 546 A1. Man sieht einen Verstärker mit Stromausgang dessen Ausgangsstrom mit einem Strom von einem digital nachgeführten DAC summiert wird. Die Kompensation ist unabhängig vom Innenwiderstand des Sensors aber das Problem der möglichen Übersteuerung bei kleinem Sensorsignal bleibt. Zwar haben Strom-Schaltungen einen höheren Dynamikbereich als Spannungsschaltungen, dennoch ist dieses Vorgehen vor allem bei hohen Verstärkungen nicht optimal. Außerdem sind Stromausgänge meist nicht so linear und im Verstärkungsfaktor nicht so temperaturstabil wie Spannungsausgänge.

Sehr hohe Verstärkung eines Sensorsignals ist so nicht machbar.

2. Offsetkompensation durch Addition bzw. Subtraktion eines digital geregelten Signals vor dem Verstärker

Die US 2003/0178989A1 zeigt die Anwendung einer Summiererschaltung vor dem Verstärker. Dadurch kann der Verstärker nicht mehr durch den Offset übersteuert werden. Die Addiererschaltung liegt aber im rausch- und verzerrungsempfindlichen Teil der Schaltung und ist damit dann die Hauptquelle für stochastische Störungen und nichtlineare Verzerrung. Ein hochgenaues System ist so nicht zu erreichen.

3. Offsetkompensation im Sensor durch feste Einspeisung eines temperaturabhängigen Stroms

Die EP 0525235 beschreibt, wie ein Kompensationsstrom von der Temperatur abhängig mit konstanten und einstellbaren linearen und quadratischen Anteilen realisiert ist, die einmal nach der Fertigung für jedes Sensorsystem eingestellt werden. Dies dient in diesem Beispiel dazu, den Zeitpunkt eines dem Sensor nachgeschalteten Komparators um einen sehr großen, aber temperaturkonstanten Betrag zu verschieben, da nicht der Sensor, sondern ein dauernd vorhandenes externes Magnetfeld erst beim Anschwellen über diesen Betrag ein Umschalten auslösen soll. Über die Temperatur hinausgehende Einflüsse auf den Offset des Sensors bleiben unkompensiert, wie beispielsweise die Änderung der Temperaturcharakteristik über die Zeit.

Die Notwendigkeit der Kalibrierung bei mehreren Temperaturen ist langwierig und teuer.

Die EP 0 464 391 A1 bezieht sich auf eine Messeinrichtung und ein Verfahren zu deren Betriebseinstellung. Bei der Messeinrichtung, die beispielsweise zur Messung eines Abstands zwischen einem Sensor und einem Werkstück dient, kommt eine geregelte, phasenabhängige Stromquelle zum Einsatz, der eine Wechsel-Speisegröße zugeführt wird, welcher über einen Rückkopplungszweig der phasenabhängigen Stromquelle eine am Sensor anliegende Wechsel-Messgröße überlagert wird. Ein Phaseneinstellglied ist zur Einstellung einer Phasenverschiebung zwischen der Wechsel-Speisegröße und der Wechsel-Messgröße im Rückkopplungszweig der phasenabhängigen Stromquelle angeordnet. Durch Veränderung der Phasenverschiebung zwischen den genannten Größen lässt sich für jeweils einen Sensor die Kennlinie zwischen der Mess-Wechselgröße und dem Abstand d linearisieren, so dass die Dynamik eines Regelkreises eines Sensorsystems zur Führung des Sensors relativ zum Werkstück unabhängig vom Abstand d ist.

Zusammenfassung der Erfindung

Es ist eine Aufgabe der vorliegenden Erfindung, ein Konzept zu schaffen, welches eine Sensoranordnung mit einer geringeren Empfindlichkeit gegenüber Störeinflüssen ermöglicht.

Diese Aufgabe wird gelöst durch eine Sensoranordnung gemäß Anspruch 1, eine Sensoranordnung gemäß Anspruch 8, sowie durch ein Verfahren gemäß Anspruch 14 und ein Verfahren gemäß Anspruch 15.

Einige Ausführungsbeispiele der vorliegenden Erfindung schaffen eine Sensoranordnung mit einem Stromregler, einem Referenzwiderstand, einem Einspeisestromskalierer und einem Sensorelement mit einem Innenwiderstand. Der Innenwiderstand des Sensorelements und der Referenzwiderstand weisen ein vorgegebenes Verhältnis zueinander auf. Der Stromregler ist ausgebildet, um einen Referenzstrom durch den Referenzwiderstand bereitzustellen und um ansprechend auf einen störeinflussbedingte Änderung des Referenzwiderstands den Referenzstrom so zu verändern, dass die über den Referenzwiderstand abfallende Spannung in einem vorgegebenen Bereich um eine angelegte Sollspannung bleibt. Ferner ist der Stromregler ausgebildet, dem Einspeisestromskalierer einen Einspeisestrom bereitzustellen und um einen Betrag des Einspeisestroms in Abhängigkeit von einem Betrag des Referenzstroms zu verändern. Der Einspeisestromskalierer ist ausgebildet, um basierend auf dem Einspeisestrom einen skalierten Einspeisestrom in das Sensorelement einzuspeisen, um eine über den Innenwiderstand des Sensorelements abfallende Spannung entsprechend der Skalierung des Einspeisestroms zu skalieren. Mit anderen Worten skaliert der Einspeisestromskalierer den skalierbaren Einspeisestrom, was damit auch eine Skalierung der über den Innenwiderstand des Sensorelements abfallenden Spannung zur Folge hat.

Es ist eine Idee, dass eine Sensoranordnung geschaffen werden kann, welche unempfindlicher gegenüber Störeinflüssen ist als die im einleitenden Teil dieser Schrift beschriebenen Sensoranordnungen, wenn ein Einspeisestrom in ein Sensorelement einer solchen Sensoranordnung eingespeist wird, der in dem Sensorelement eine Spannung erzeugt, die in Abhängigkeit von der Veränderung eines Referenzstroms durch einen Referenzwiderstand verändert wird. Dieser Einspeisestrom kann beispielsweise dazu benutzt werden, um die Auswirkungen von störeinflussbedingten Änderungen in dem Sensorelement zu reduzieren. Aufgrund der Veränderung des Einspeisestroms in das Sensorelement und damit der in dem Sensorelement abfallenden Spannung in Abhängigkeit von der Veränderung des Referenzstroms wird ermöglicht, dass ansprechend auf eine Veränderung des Störeinflusses, welche anhand der Veränderung der über den Referenzwiderstand abfallenden Spannung erkannt wird, auch der Einspeisestrom verändert. Dies kann in solcher Weise geschehen, dass die durch den Einspeisestrom über den Innenwiderstand des Sensorelements abfallende Spannung zwar skalierbar im Verhältnis zur angelegten Sollspannung ist, aber durch den Störeinfluss nahezu unverändert bleibt. Dadurch wird eine störeinflussabhängige Regelung der über dem Innenwiderstand des Sensorelements abfallenden Spannung ermöglicht.

Einige weitere Ausführungsbeispiele schaffen eine Sensoranordnung mit einem Spannungsregler, einem Einspeisestromskalierer und einem Sensorelement mit einem Innenwiderstand. Der Spannungsregler ist ausgebildet, um eine Speisespannung für das Sensorelement einzustellen und um ansprechend auf eine störeinflussbedingte Veränderung des Innenwiderstands des Sensorelements einen Speisestrom des Sensorelements so zu verändern, dass die Speisespannung für das Sensorelement in einem vorgegebenen Bereich bleibt. Der Spannungsregler ist ferner ausgebildet, um dem Einspeisestromskalierer einen Einspeisestrom bereitzustellen und um diesen Einspeisestrom in Abhängigkeit der Veränderung des Speisestroms für das Sensorelement zu ändern. Der Einspeisestromskalierer ist ausgebildet, um basierend auf dem Einspeisestrom einen skalierten Einspeisestrom in das Sensorelement einzuspeisen, um eine über den Innenwiderstand des Sensorelements abfallende Spannung entsprechend der Skalierung des Einspeisestroms zu skalieren.

Es ist eine Idee von diesen weiteren Ausführungsbeispielen, dass eine Sensoranordnung geschaffen werden kann, die resistenter gegen Störeinflüsse ist als Sensoranordnungen, wie sie im einleitenden Teil bisher beschrieben wurden, wenn in ein Sensorelement einer solchen Sensoranordnung ein (skalierter) Einspeisestrom eingespeist wird, der in Abhängigkeit von einer Veränderung des Speisestroms für das Sensorelement geändert wird. Der in das Sensorelement eingespeiste Einspeisestrom erzeugt in dem Sensorelement eine Spannung, die beispielsweise einem Offset entgegen wirkt. Da die Größe der auszugleichenden Offsets jedoch stochastisch verteilt ist, wird durch geeignete Skalierung der im Sensor durch den Einspeisestrom abfallenden Spannung dem Offset entgegengewirkt. Aus dem durch Störeinflüsse veränderten Innenwiderstand des Sensors folgt für gleichen Spannungsabfall ein, der Störeinflussänderung nachgeregelter Speisestrom. Ausführungsbeispiele nutzen daher die Veränderung des Speisestroms für das Sensorelement als Referenz für eine Veränderung des Einspeisestroms und benötigen daher keine zusätzlichen Komponenten, um eine Veränderung des Innenwiderstands des Sensorelements zu detektieren, um dann den Einspeisestrom entsprechend anzupassen. Es kann bei einem Sensorelement eine Speisespannung des Sensorelements durch Anpassung des Speisestroms konstant gehalten werden, um das Sensorelement immer in seinem optimalen Betriebsbereich zu betreiben. Dieses Konstanthalten der Speisespannung erfolgt dabei über das Regeln des Speisestroms für das Sensorelement. Ausführungsbeispiele nutzen dabei die durch einen Störeinfluss des Innenwiderstands hervorgerufene Veränderung des Speisestroms (die dazu dient, die Speisespannung für das Sensorelement konstant zu halten) als Basis für die Veränderung des Einspeisestroms, um so auch bei der im Sensorelement durch den Einspeisestrom abfallenden Spannung den Veränderungen der Störeinflüsse Rechnung zu tragen.

Es ist ein Vorteil von diesen Ausführungsbeispielen, dass als Referenz für die Einstellung des Einspeisestroms, welcher beispielsweise zur Reduktion von Offsets dienen kann, der Speisestrom für das Sensorelement selbst dient und somit eine präzise Einstellung des Einspeisestroms ansprechend auf Veränderungen der Störeinflüsse gewährleistet wird.

Die Speisespannung kann beispielsweise die Spannung sein, die zwischen zwei Versorgungsspannungsanschlüssen des Sensorelements anliegt, beispielsweise zwischen einem Speiseanschluss zur Einspeisung des Speisestroms und einem Fußpunktanschluss des Sensorelements.

Kurzbeschreibung der Figuren

Ausführungsbeispiele der vorliegenden Erfindung werden im Folgenden anhand der beiliegenden Figuren detailliert beschrieben. Es zeigen:

Fig. 1    ein Blockschaltbild einer Sensoranordnung gemäß einem Ausführungsbeispiel;

Fig. 2    ein Blockschaltbild einer Sensoranordnung gemäß einem weiteren Ausführungsbeispiel;

Fig. 3    ein Blockschaltbild einer Sensoranordnung gemäß einem weiteren Ausführungsbeispiel;

Fig. 4    ein Blockschaltbild einer Sensoranordnung gemäß einem weiteren Ausführungsbeispiel;

Fig. 5    ein Blockschaltbild einer Sensoranordnung gemäß einem weiteren Ausführungsbeispiel;

Fig. 6    ein Flussdiagramm eines Verfahrens gemäß einem Ausführungsbeispiel; und

Fig. 7    ein Flussdiagramm eines Verfahrens gemäß einem weiteren Ausführungsbeispiel.

Detaillierte Beschreibung von Ausführungsbeispielen

Bevor im Folgenden Ausführungsbeispiele der vorliegenden Erfindung anhand der beiliegenden Figuren beschrieben werden, wird darauf hingewiesen, dass gleiche Elemente oder Elemente gleicher Funktion mit denselben Bezugszeichen versehen sind, und dass auf eine wiederholte Beschreibung dieser Elemente verzichtet wird. Beschreibungen von Elementen mit denselben Bezugszeichen sind daher untereinander austauschbar.

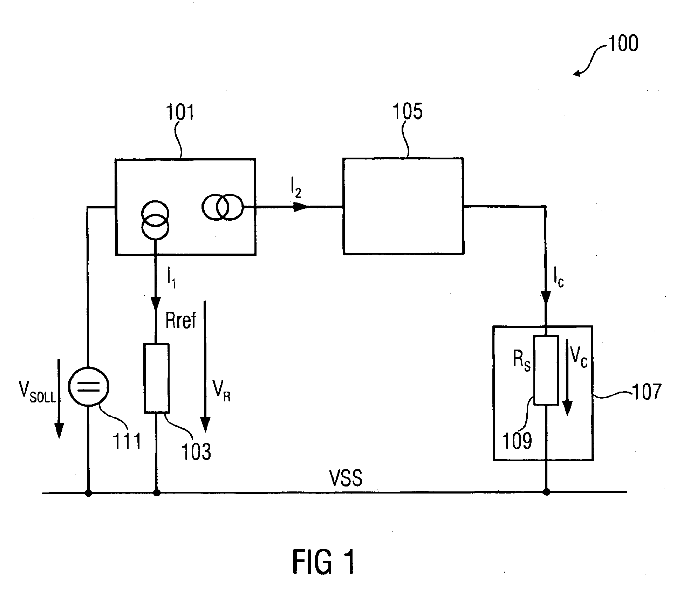

Fig. 1 zeigt ein Blockschaltbild einer Sensoranordnung 100 gemäß einem Ausführungsbeispiel der vorliegenden Erfindung.

Die Sensoranordnung 100 weist einen Stromregler 101, einen Referenzwiderstand 103 (auch bezeichnet als Rref), einen Einspeisestromskalierer 105 und ein Sensorelement 107 mit einem Innenwiderstand 109 (auch bezeichnet als Rs) auf.

Der Innenwiderstand 109 des Sensorelements 107 und der Referenzwiderstand 103 weisen ein vorgegebenes Verhältnis zueinander auf.

Der Stromregler 101 ist ausgebildet, um einen Referenzstrom $I_1$ durch den Referenzwiderstand 103 bereitzustellen und um ansprechend auf eine störeinflussbedingte Veränderung des Referenzwiderstands 103 den Referenzstrom $I_1$ so zu verändern, dass die über den Referenzwiderstand abfallende Spannung VR in einem vorgegebenen Bereich um eine angelegte Sollspannung Vsoll bleibt.

Ferner ist der Stromregler 101 ausgebildet, dem Einspeisestromskalierer 105 einen Einspeisestrom I2 bereitzustellen und um einen Betrag des Einspeisestroms I2 in Abhängigkeit von einem Betrag des Referenzstroms I1 zu verändern.

Der Einspeisestromskalierer 105 ist ausgebildet, um basierend auf dem Einspeisestrom einen skalierten Einspeisestrom Ic in das Sensorelement 107 einzuspeisen, um eine über den Innenwiderstand 109 des Sensorelements 107 abfallende Spannung Vc entsprechend der Skalierung des Einspeisestroms I2 zu skalieren.

Die über den Innenwiderstand 109 des Sensorelements 107 abfallende Spannung Vc kann beispielsweise einem Offset des Sensorelements 107 entgegenwirken. Mit anderen Worten kann in dem Sensorelement 107 mit dem skalierten Einspeisestrom Ic die Spannung Vc erzeugt werden, welche einem Offset der Sensoranordnung 107 entgegenwirkt. Aufgrund dessen, dass der Einspeisestrom I2 in Abhängigkeit von einer Veränderung des Referenzstroms I1 verändert wird und aufgrund des vorgegebenen Verhältnisses zwischen dem Referenzwiderstand 103 und dem Innenwiderstand 109 können störeinflussbedingte Veränderungen des Innenwiderstands 109, welche bei einem Konstanthalten des Einspeisestroms I2 für eine Veränderung der über den Innenwiderstand 109 abfallenden Spannung Vc führen würden, zumindest zu einem gewissen Teil ausgeglichen werden. So kann beispielsweise ermöglicht werden, dass die über den Innenwiderstand 109 abfallende Spannung Vc durch die Veränderung des Einspeisestroms I2 (nahezu) unabhängig von Störeinflüssen ist. Beispielsweise kann der Stromregler 101 den Einspeisestrom I2 so bereitstellen, dass die über den Innenwiderstand 109 abfallende Spannung Vc (trotz einer Veränderung der Störeinflüsse) in einem vorgegebenen Bereich (beispielsweise $\pm$ 10 % eines Sollwertes) bleibt. Störeinflüsse können beispielsweise Temperatur oder Alter sein.

Beispielsweise kann der Einspeisestromskalierer 105 den Einspeisestrom in Abhängigkeit von einem Ausgangssignal der Sensoranordnung 100 skalieren.

Gemäß weiteren Ausführungsbeispielen kann der Einspeisestromskalierer aber auch Kalibrierwerte aufweisen, basierend auf denen er den Einspeisestrom I2 skaliert, beispielsweise um einen Sensoroffset des Sensorelements 107 zu reduzieren.

Gemäß weiteren Ausführungsbeispielen kann die Sensoranordnung 100 ferner eine Störeinfluss unabhängige Referenzspannungsquelle 111 zur Erzeugung der Sollspannung Vsoll aufweisen. Beispielsweise kann die Störeinfluss unabhängige Referenzspannungsquelle 111 eine temperaturstabile Referenzspannungsquelle sein.

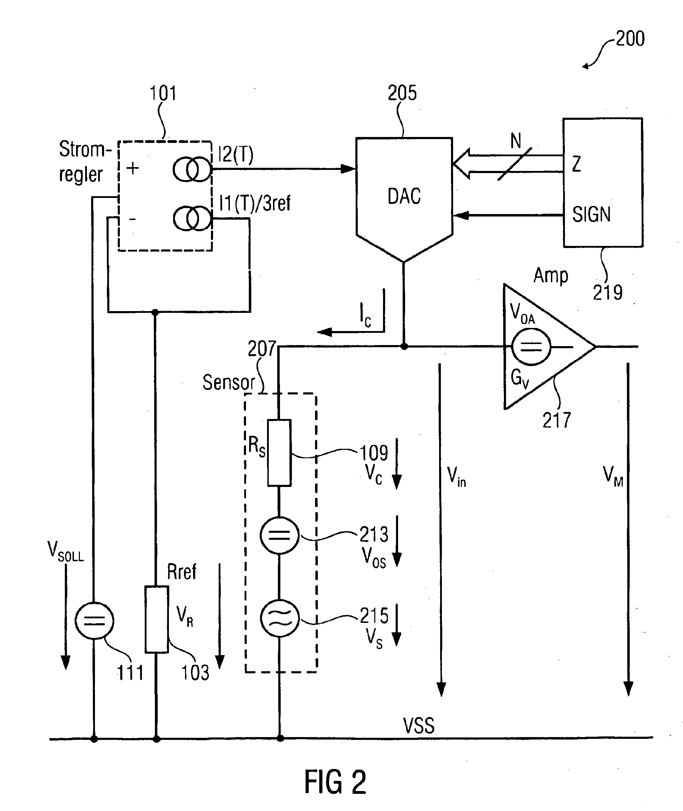

Fig. 2 zeigt eine Sensoranordnung 200 gemäß einem weiteren Ausführungsbeispiel. Die Sensoranordnung 200 unterscheidet sich von der in Fig. 1 gezeigten Sensoranordnung 200 dadurch, dass der Skalierer 105 als ein DAC 205 (DAC - digital to analoge converter, Digital/Analogwandler) ausgebildet ist. Weiterhin ist in Fig. 2 ein reales Sensorelement 207 (auch als Sensor 207 bezeichnet) gezeigt, welches zusätzlich zu dem Innenwiderstand 109 eine Offsetquelle 213 und eine Sensorspannungsquelle 215 aufweist. Weiterhin weist die Sensoranordnung 200 einen Ausgangsverstärker 217 (auch als AMP bezeichnet) auf.

Bei der in Fig. 2 gezeigten Sensoranordnung 200 soll das Signal des Sensorelements 207, also die Sensorspannung Vs ausgewertet werden. Das in Fig. 2 gezeigte Ersatzschaltbild des Sensors 202 zeigt den Innenwiderstand 109 (Rs), das Nutzspannungssignal Vs (welches auszuwerten ist) und das unerwünschte Offsetspannungssignal VOS. Die am Eingang des Ausgangsverstärkers 217 anliegende Spannung Vin wird durch den Verstärker 217 um den Faktor Gv verstärkt und als Signal VM (beispielsweise in Form eines Stroms oder einer Spannung) zur weiteren Verarbeitung ausgegeben.

Aus bestimmten Gründen ist es erwünscht, $V_S$ möglichst hoch zu verstärken, also Gv möglichst groß zu wählen. Dabei sind die Offsetspannung des Sensors 207 VOS und des Verstärkers 217 VOA hinderlich, denn diese werden ebenfalls verstärkt. Insbesondere bei Offsetspannungen, die im Verhältnis zur Nutzspannung (VS) sehr groß sind, wird der Verstärker 217 am Ausgang schon durch die Verstärkung der Offsetspannungen VOS, VOA übersteuert. Vom Nutzsignal (VS) ist am Ausgang des Verstärkers 217 dann nichts mehr sichtbar.

Deshalb wird zur Kompensation der Offsetspannungen VOS, VS in den Sensor 207 der skalierte Einspeisestrom oder Kompensationsstrom Ic eingespeist. Dieser skalierte Einspeisestrom Ic kann von dem Einspeisestromskalierer 205 so eingestellt werden, dass er am Innenwiderstand 109 des Sensors 207 die Spannung Vc erzeugt, die den Offsetspannungen entgegenwirkt und sie damit kompensiert oder zumindest reduziert.

Das in Fig. 2 gezeigte Ausführungsbeispiel ermöglicht damit einen Sensoroffset zusammen mit einem Verstärkeroffset auszugleichen oder wenigstens zu reduzieren. Der in das Sensorelement 207 eingespeiste skalierte Einspeisestrom Ic ist temperaturabhängig und kann mit Hilfe des Einspeisestromskalierers 205 digital nachgeregelt werden.

Beispielsweise kann der Stromregler 101 den Referenzstrom I1 (T) so steuern, dass die durch ihn am Referenzwiderstand 103 erzeugte Spannung VR der Referenzspannung Vsoll zumindest innerhalb eines Toleranzbereichs entspricht.

Der Toleranzbereich kann beispielsweise $\pm 10\%$, $\pm 5\%$, $\pm 1\%$ von der Referenzspannung Vsoll betragen.

Der Störeinfluss kann beispielsweise die Temperatur T sein.

Der Referenzstrom I1 (T) ist damit abhängig von der Temperatur T. Davon abhängig (beispielsweise proportional dazu) ist der (Einspeise-)Strom I2(T). Dieser wird im DAC 205 von einem Reglerwert Z und einem Vorzeichen SIGN gewichtet und beispielsweise als Kompensationsstrom Ic in den Sensor 207 eingespeist.

Gemäß weiteren Ausführungsbeispielen kann die Sensoranordnung 200 einen digitalen Regler 219 aufweisen. Dieser überlagerte digitale Regler 219 kann mit einem vorgegebenen Algorithmus, beispielsweise aus dem mit der Auflösung von M Bit (mit M $\geq$ 1) digitalisierten Ausgangssignal VM, den digitalen Stellwert Z und das Vorzeichen SIGN ermitteln. Der überlagerte (digitale) Regler 219 stellt mit dem Digitalwert Z die Spannung Vc am Sensor ein, obwohl die Methode einen Strom (den skalierten Einspeisestrom Ic) durch einen unbekannten Widerstand RS benutzt. Dies bedeutet für den Nutzer, dass er direkt vom Reglerwert Z auf die Größe der Offsetsumme schließen kann oder andersherum von bekannter Offsetspannung direkt auf einen optimalen Korrekturwert schließen kann.

Der Wert für die digitale Nachführung ist unabhängig von der Temperatur und deshalb ist die Schleifenverstärkung für den überlagerten digitalen Regler 219 konstant, was einen Vorteil für die Robustheit des Systems bietet. Der digitale Regler 219 kann deutlich schneller ausgelegt werden. Im optimalen Fall kann in einem Schritt der optimale Korrekturwert eingestellt werden.

Die digitale Nachregelung selber sorgt auch bei Änderung der Charakteristik des Offsets über der Temperatur und bei zusätzlichen Einflüssen, die sich als Offset auswirken noch für eine sichere Kompensation des Offsets.

Die einstellbare Quelle wird mit weniger Aufwand ansteuerbar. Vor allem auch die Anzahl der notwendigen digitalen Stufen wird deutlich reduziert.

Zusammenfassend schaffen Ausführungsbeispiele eine Sensoranordnung, bei der eine Sensor- und eine Verstärkeroffsetspannung korrigiert werden.

Referenz für die maximale Größe des Spannungssignals Vc am Sensor ist eine temperaturkonstante Referenzspannung Vsoll.

Mittel zur Generierung der Korrektur ist ein Einspeisestrom Ic.

Die Generierung des Kompensationssignals Vc geschieht direkt im Sensor ohne weitere Einrichtung im Signalpfad durch lineare Überlagerung der Sensorspannung mit einer von diesem Strom Ic am Sensorinnenwiderstand 109 generierten Spannung Vc.

Der Maximalwert des Stroms I2 wird über die Temperatur so geregelt, dass im Sensor eine über die Temperatur konstante Spannung Vc entsteht.

Um den Wert den zufällig verteilten und zeitlich varianten Werten der Sensoroffsetspannung VOS und der Verstärkeroffsetspannung VOA anzupassen kann - abhängig von einem digitalen Stellsignal (Z, SIGN) auch nur ein Anteil des Maximalwerts des Stroms I2 in den Sensor geleitet werden (der skalierte Einspeisestrom Ic). Dadurch entsteht eine anteilig kleinere Korrekturspannung, die ebenfalls konstant ist über der Temperatur.

Die Einstellung des digitalen Stellwertes Z, SIGN kann durch den übergeordneten digitalen Regler 219 bewerkstelligt werden.

Reglerbereich und Auflösung der einstellbaren Schaltung bleibt überschaubar, denn der Temperaturrückgang des Sensorinnenwiderstands wird durch die Stromskalierung berücksichtigt, so dass gemäß weiteren Ausführungsbeispielen, es ausreichend ist, wenn die Schaltung nur noch den Temperaturrückgang, bzw. die Drifts der Offsets und die Abweichung des Temperaturgangs des Sensorinnenwiderstands von einem erwarteten Wert abdeckt.

Ausführungsbeispiele können beispielsweise in einem spinning current System angewendet werden.

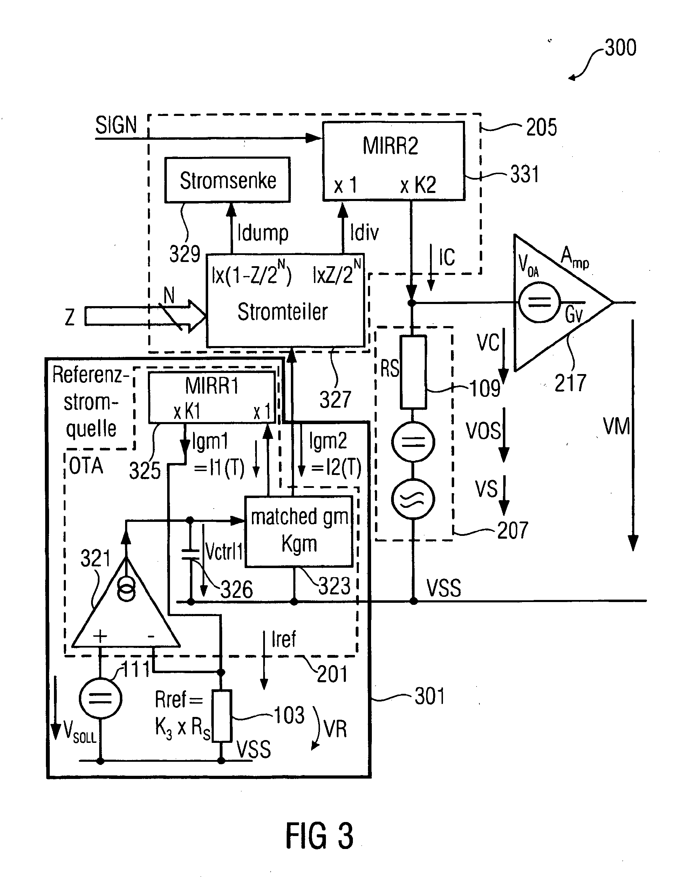

Fig. 3 zeigt eine Sensoranordnung 300 gemäß einem weiteren Ausführungsbeispiel der vorliegenden Erfindung. Die Sensoranordnung 300 unterscheidet sich von der in Fig. 2 gezeigten Sensoranordnung 200 dadurch, dass eine mögliche Implementierung des DAC 205 bzw. des Einspeisestromskalierers 205 gezeigt ist. Weiterhin weist die Sensoranordnung 300 eine Referenzstromquelle 301 auf, welche den Referenzwiderstand 103 sowie die temperaturstabile Referenzspannungsquelle 111 und den Stromregler 201 umfasst. Zusätzlich ist eine mögliche Implementierung des Stromreglers 201 gezeigt.

Der Referenzwiderstand 103 kann so ausgebildet sein, dass bestimmte Störeinflüsse die Änderungen des Innenwiderstands 109 des Sensorelements 207 bewirken, im entsprechenden Verhältnis die Größe des Referenzwiderstands 103 ändern, so dass die über den Innenwiderstand 109 des Sensorelements 207 abfallende Spannung VC innerhalb eines Toleranzbereichs unabhängig von diesen Störeinflüssen ist.

So kann beispielsweise der Referenzwiderstand 103 denselben Störeinflüssen ausgesetzt sein wie der Innenwiderstand 109 des Sensorelements 207. Beispielsweise können der Referenzwiderstand 103 sowie der Innenwiderstand 109 auf demselben Substrat, und beispielsweise in demselben Halbleiterprozess hergestellt worden sein.

In einem Ausführungsbeispiel wird die Charakteristik des Einspeisestrom I2 (T) über der Temperatur T von dem Referenzwiderstand 103 gleichen Materials und entsprechend skalierter Geometrie wie der Sensorinnenwiderstand 109 abgeleitet.

Mit anderen Worten kann ein Material des Referenzwiderstands 103 und ein Material des Innenwiderstands 109 innerhalb eines Toleranzbereichs dasselbe Verhalten gegenüber einem Störeinfluss aufweisen, derart, dass eine durch einen solchen Störeinfluss hervorgerufene Änderung des Referenzwiderstands 103 eine gleichgerichtete und entsprechend dem Verhältnis zwischen dem Referenzwiderstand 103 und dem Innenwiderstand 109 skalierte Änderung des Innenwiderstands 109 des Sensorelements 207 hervorruft.

Der Toleranzbereich kann hier beispielsweise sehr klein sein, wenn für den Referenzwiderstand 103 und den Innenwiderstand 109 dasselbe Material gewählt wird.

Gemäß weiteren Ausführungsbeispielen kann aber auch ein ähnliches Material für die beiden Widerstände 103 und 109 gewählt werden. Hier kann der Toleranzbereich beispielsweise so gewählt werden, dass ein Temperaturkoeffizient des Materials des Innenwiderstands 109 maximal um $\pm$ 20 %, $\pm$ 10 %, $\pm$ 5 % oder $\pm$ 1 % von einem Temperaturkoeffizienten des Materials des Referenzwiderstands 103 abweicht.

Weiterhin können Abmessungen des Referenzwiderstands 103 entsprechend dem Verhältnis zwischen dem Referenzwiderstand 103 und dem Innenwiderstand 109 des Sensorelements 207 mit Abmessungen des Innenwiderstands 109 des Sensorelements 207 skalieren.

So kann beispielsweise ein Widerstandswert des Innenwiderstands 109 des Sensorelements 207 unbekannt sein, jedoch können Abmessungen des Innenwiderstands 109 bekannt sein, so dass Abmessungen des Referenzwiderstands 103 entsprechend einem Skalierungsverhältnis K3 zwischen dem Referenzwiderstand 103 und dem Innenwiderstand 109 gewählt werden. Wird nun auch das Material des Referenzwiderstands 103 gleich dem Material des Innenwiderstands 109 gewählt und werden diese beiden Widerstände in einem gemeinsamen Halbleiterprozess gefertigt, so kann, obwohl der Widerstandswert des Innenwiderstands 109 unbekannt ist, sichergestellt werden, dass zumindest das Verhältnis K3 zwischen dem Referenzwiderstand 103 und dem Innenwiderstand 109 korrekt ist. Der Referenzwiderstand 103 bildet daher einen sogenannten Replikawiderstand des Innenwiderstands 109 mit dem Skalierungsverhältnis K3.

So kann beispielsweise ermöglicht werden, dass ein Widerstandswert des Referenzwiderstands 103 eine temperaturbedingte Änderung des Innenwiderstands 109 des Sensorelements 207 entsprechend dem Verhältnis zwischen dem Referenzwiderstand 103 und dem Innenwiderstand 109 erfährt.

Der Stromregler 201 weist einen Regelverstärker 321 (auch bezeichnet als OTA) sowie einen Strombereitsteller auf. Der Strombereitsteller weist in dem in Fig. 3 gezeigten Ausführungsbeispiel eine gm-Stufe 323 und einen optionalen ersten Stromspiegel 325 (MIRR1) auf. Der Einspeisestrom I2 (T) wird in seiner maximalen Größe in der gm-Stufe 323 erzeugt und durch Abzweigen eines Anteils (im DAC 205) wird der rauscharme skalierte Einspeisestrom Ic erzeugt, der den Offset ausgleichen kann. Jede Erhöhung der Auflösung fügt einen kleineren Strom hinzu, der für sich alleine wenig rauscht. Der Maximalstrom I2 (T) bleibt hingegen in der Rauschcharakteristik unverändert.

Weiterhin weist der Einspeisestromskalierer 205 einen Stromteiler 327, eine Stromsenke 329 und einen zweiten Stromspiegel 331 (auch bezeichnet als MIRR2) auf.

Im Folgenden soll die Funktionsweise der in Fig. 3 gezeigten Sensoranordnung detailliert beschrieben werden.

Der Regelkreis mit OTA, gm-Stufe (Spannung Vctrl1 nach Strom Igm1 und Igm2 Wandler), 1. Stromspiegel MIRR1 und Referenzwiderstand Rref regelt Iref so aus, dass die Spannung am Referenzwiderstand der Referenzspannung Vsoll innerhalb eines Toleranzbereichs entspricht.

Die Ausgangsströme Igm2 und Igm1 sind durch den Faktor Kgm miteinander verbunden, da sie vom gleichen Vctrl1 gesteuert werden:

$$Igm2 \: / \: Igm1 = Kgm \qquad\qquad (1)$$

Kgm sollte nahe bei 1 liegen, um ein gutes Matching (und hohe Korrelation) zwischen beiden Strömen zu bekommen.

Im Stromspiegel 325 wird der Strom Igm1 mit dem Faktor 1/K1 in den Strom Iref übersetzt. Der Strom Igm2, abhängig von der Temperatur T, ist dadurch proportional zum Strom Iref durch den Referenzwiderstand:

$$Igm2(T) = Iref(T) * Kgm/K1 \qquad\qquad (2)$$

Wird die matched-gm-Stufe 323 (angepasste gm-Stufe) gegen positive Versorgung VDD geschaltet, dann kann der Spiegel MIRR1 weggelassen werden. K1 wird dann zu 1 gesetzt.

Im Stromteiler wird ein Teil des Stromes Idump abgezweigt und in die Stromsenke geleitet, die für einen guten Abschluss des Stromteilerausgangs Idump sorgt. Das Verhältnis Idiv/Igm2 wird mit dem N-Bit breiten Binärsignal Z eingestellt.

$$Idiv(T) = Iref(T) * Z/2^N * Kgm/K1 \: ; \: Z = [0, 1, ... , 2^N\text{-}1] \qquad (3)$$

Der zweite Stromspiegel MIRR2 mit einem Spiegelverhältnis K2, das wiederum nahe an 1 liegen sollte, leitet den Rest des Stroms Idiv vorzeichenrichtig als Ic an den Sensor weiter. Das Vorzeichen wird mit dem Binärsignal SIGN eingestellt.

$$Ic(T) = +/- \: Iref(T) * K2 * Z/2^N * Kgm/K1 \qquad\qquad (4)$$

Da Iref so geregelt wird, dass die Spannung an Rref der Referenzspannung Vsoll entspricht, gilt:

$$Iref(T) = Vsoll \: / \: (Rs(T) * K3) \qquad\qquad (5)$$

und damit

$$Vc = Rs(T) * Ic(T) = +/- Rs(T) * Iref(T) * K2 * Z/2^N * Kgm/K1$$
$$= +/- Rs(T) * (VRef / (Rs(T) * K3)) * K2 * Z/2^N * Kgm/K1 \qquad (6)$$

Dabei kürzt sich Rs(T) wieder heraus und die im Sensor generierte Spannung Vc ist wieder unabhängig vom Sensorinnenwiderstand und damit auch von dessen Temperaturgang:

$$Vc = +/- (VRef/K3) * K2 * (Z/2^N) * (Kgm/K1) \qquad (7)$$

Die Einstellauflösung ΔVc ist:

$$\Delta Vc = (Vsoll/K3) * K2 * (1/2^N) * (Kgm/K1) \qquad (8)$$

Mit der Einstellung

$$Vc (T) = (-1/2 \ldots +1/2) * \Delta Vc - [ Vos(T) + Voa(T) ] \qquad (9)$$

bleibt nur noch der Nutzanteil und ein Rest des Offsets übrig.

Die Ausgangsspannung ist dann

$$Vout = Gv * Vs + Gv * (-1/2 \ldots +1/2) * \Delta Vc$$
$$= Gv * Vs + Gv * (-1/2 \ldots +1/2) * (Vsoll/K3) * K2 * (1/2^N) * (Kgm/K1). \quad (10)$$

K1, K2, K3 und Kgm können nahe 1 gewählt werden (beispielsweise größer 0.9 und kleiner 1.1 , denn $1/2^N$ legt die Auflösung fest.

Die Schaltung ist Rauscharm und ermöglicht durch eine kleine Einstellauflösung ΔVc hohe Verstärkungen Gv.

Zusammenfassend zeigt die Sensoranordnung 300 in Fig. 3 eine Sensoranordnung mit einer temperaturstabilen Referenzspannungsquelle 111 zur Erzeugung der Sollspannung Vsoll. Der Stromregler 205 ist ausgebildet, um den Referenzstrom Iref (auch bezeichnet als I1) so zu regeln, dass die Spannung VR am Referenzwiderstand 103 innerhalb eines vorgegebenen Toleranzbereichs der Sollspannung Vsoll entspricht. Beispielsweise kann die Referenzspannung VR so gewählt werden, das sie maximal um ±10%, ±5%, ±1% von der Sollspannung Vsoll abweicht.

Am Kondensator 326 wird das Stromausgangssignal des OTAs 321 aufsummiert und es entsteht die Spannung Vctrl1, welche einen integralen Wert der Abweichung der über den Referenzwiderstand 103 abfallenden Spannung VR von der Sollspannung Vsoll beschreibt. Der Strombereitsteller (die matched gm-Stufe 323 in Verbindung mit dem ersten Stromspiegel 325) ist ausgebildet, um basierend auf dem Differenzsignal den Referenzstrom Iref und den Einspeisestrom I2 bereitzustellen, derart, dass der Einspeisestrom I2 proportional zu dem Referenzstrom Iref ist.

Der Stromregler 205 und der Referenzwiderstand 103 können ausgebildet sein, um die Veränderung des Einspeisestroms I2 in Abhängigkeit der Veränderung des Referenzstroms I1 so durchzuführen, dass bei der störeinflussbedingten Änderung des Referenzwiderstands 103 und einer damit einhergehenden störeinflussbedingten Änderung des Innenwiderstands 109 des Sensorelements 207 die über den Innenwiderstand 109 abfallende Spannung Vc in einem vorgegebenen Bereich (beispielsweise konstant) bleibt.

So kann beispielsweise einer Veränderung des Innenwiderstands 109 aufgrund veränderter Störeinflüsse entgegengewirkt werden, so dass trotz der veränderten Störeinflüsse die Spannung über dem Innenwiderstand 109 konstant bleibt, beispielsweise um den Verstärkeroffset VOA und den Sensoroffset VOS zu reduzieren bzw. zu kompensieren.

Beispielsweise kann die über den Innenwiderstand 109 abfallende Spannung Vc so gewählt werden, dass sie zu mindest 80 %, 90 %, 95 % der Summe aus dem Sensoroffset Vos und dem Verstärkeroffset Voa entspricht und ein zu der Summe entgegensetztes Vorzeichen hat.

Mit anderen Worten kann die Sensoranordnung 200 ausgebildet sein, um die über den Innenwiderstand 109 des Sensorelements 207 abfallende Spannung Vc derart zu erzeugen, dass diese einem Offsetanteil in einem Ausgangssignal VM der Sensoranordnung (beispielsweise an einem Ausgang des Ausgangsverstärkers 217) entgegenwirkt.

Beispielsweise kann der Stromregler 101 ausgebildet sein, um den Betrag des Einspeisestroms I2 proportional zum Betrag des Referenzstroms I1 zu verändern, in einem Verhältnis, das sich ergibt aus dem Verhältnis zwischen Referenzwiderstand 103 und Innenwiderstand 109 des Sensorelements 207 und aus einem Verhältnis zwischen der Sollspannung Vsoll und einer, bei keiner oder minimalen Skalierung des Einspeisestroms I2 abfallenden Spannung Vc über den Innenwiderstand 109. Eine minimale Skalierung soll dabei bedeuten, dass der Einspeisestromskalierer 205 den empfangenen Einspeisestrom I2 direkt an das Sensorelement 207 weiterleitet, ohne diesen zu skalieren.

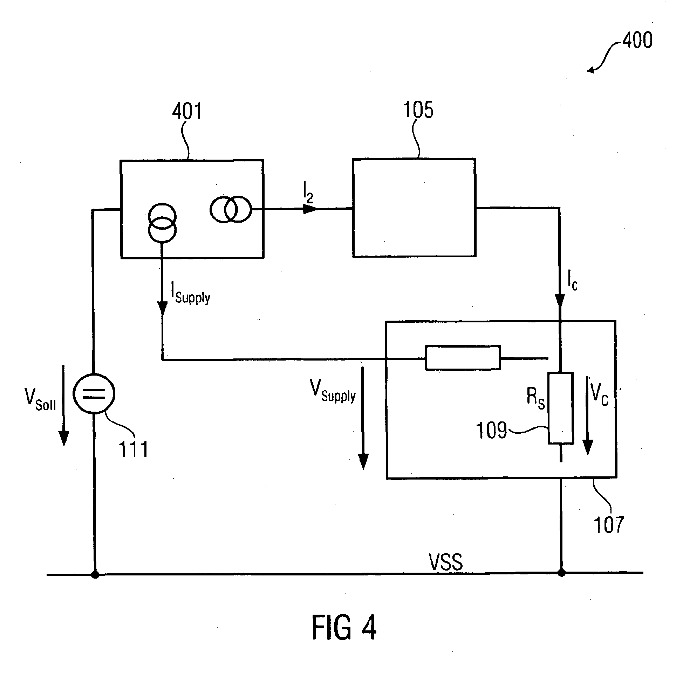

Fig. 4 zeigt eine Sensoranordnung 400 gemäß einem weiteren Ausführungsbeispiel der vorliegenden Erfindung.

Die Sensoranordnung 400 weist einen Spannungsregler 401, einen Einspeisestromskalierer 105 und ein Sensorelement 107 mit einem Innenwiderstand 109 (auch bezeichnet als Rs) als Teil einer, als Netzwerk mit resistiven Anteilen modellierbaren, Sensor-Ersatzschaltung auf.

Der Spannungsregler 401 ist ausgebildet, um eine Speisespannung Vssupply für das Sensorelement 107 einzustellen und um ansprechend auf eine störeinflussbedingte Veränderung des Innenwiderstands 109 des Sensorelements 107 einen Speisestrom Isupply des Sensorelements 107 so zu verändern, dass die Speisespannung Vssupply für das Sensorelement 107 in einem vorgegebenen Bereich (beispielsweise innerhalb eines Toleranzbereichs konstant) bleibt.

Der Spannungsregler 401 ist ferner ausgebildet, um dem Einspeisestromskalierer 105 einen Einspeisestrom I2 bereitzustellen, und um diesen Einspeisestrom I2 in Abhängigkeit der Veränderung des Speisestroms Isupply für das Sensorelement 107 zu ändern.

Der Einspeisestromskalierer 105 ist ausgebildet, um basierend auf dem Einspeisestrom I2 einen skalierten Einspeisestrom Ic in das Sensorelement einzuspeisen, um eine über den Innenwiderstand des Sensorelements abfallende Spannung Vc entsprechend der Skalierung des Einspeisestrom I2 zu skalieren.

Wie auch schon bei den vorherigen Ausführungsbeispielen kann die, aufgrund des skalierten Einspeisestroms Ic über den Innenwiderstand 109 des Sensorelements 107 abfallende Spannung Vc genutzt werden, um einen Offset des Sensorelements 107 (und einen Verstärkeroffset) zu reduzieren, beispielsweise um diesem entgegenzuwirken. Im Gegensatz zu den vorherigen Ausführungsbeispielen wird bei dem in Fig. 4 gezeigten Ausführungsbeispiel kein Referenzwiderstand mehr benötigt, sondern der Speisestrom Isupply des Sensorelements 107 selber dient als Basis für die Einstellung des Einspeisestroms I2. Der Spannungsregler 401 kann daher basierend auf der Veränderung des Speisestroms Isupply, (die der Spannungsregler 401 durchführt, um die Speisespannung Vssupply in dem vorgegebenen Bereich zu halten) den Strom I2 und damit den skalierten Einspeisestrom Ic zu verändern, so dass auch die über den Innenwiderstand 109 abfallende Spannung Vc in einem vorgegebenen Bereich (beispielsweise innerhalb eines Toleranzbereichs konstant) bleibt.

Gemäß einem Ausführungsbeispiel kann der Spannungsregler 401 ausgebildet sein, um den Einspeisestrom I2 so einzustellen, dass eine Änderung des Einspeisestroms I2 (zumindest innerhalb eines Toleranzbereichs) proportional zu einer Änderung des Speisestroms Isupply ist. Der Toleranzbereich kann hier beispielsweise so gewählt werden, dass die Änderung des Einspeisestroms I2 maximal um $\pm$ 10 %, $\pm$ 5 % oder $\pm$ 1 % von der Änderung des Einspeisestroms Isupply abweicht.

Gemäß weiteren Ausführungsbeispielen kann der Spannungsregler 401 auch ausgebildet sein, um den Einspeisestrom I2 so einzustellen, dass ein Monotonieverhalten zwischen dem Einspeisestrom I2 und dem Speisestrom Isupply identisch ist, d.h., dass der Einspeisestrom I2 steigt, wenn der Speisestrom Isupply steigt und der Einspeisestrom I2 sinkt, wenn der Speisestrom Isupply sinkt.

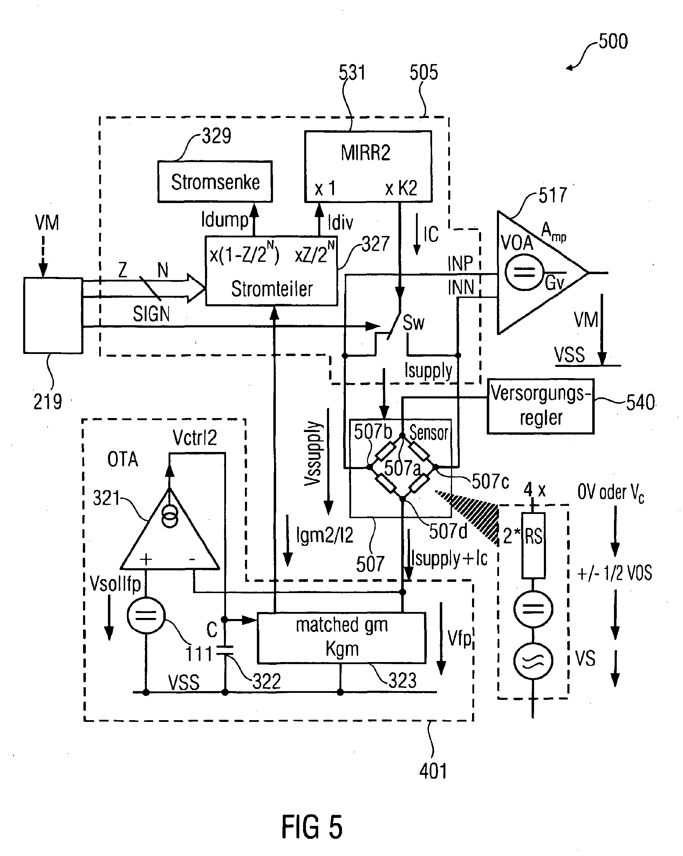

Fig. 5 zeigt eine Sensoranordnung 500 gemäß einem weiteren Ausführungsbeispiel der vorliegenden Erfindung. Die in Fig. 5 gezeigte Sensoranordnung 500 unterscheidet sich von der in Fig. 4 gezeigten Sensoranordnung 400 dadurch, dass eine mögliche Implementierung des Spannungsreglers 401 gezeigt ist. In dem in Fig. 5 gezeigten Ausführungsbeispiel ist der Spannungsregler 401 als ein Fußpunktregler 401 ausgebildet. Weiterhin zeigt Fig. 5 eine mögliche Implementierung des Einspeisestromskalierers 105 in Form eines DAC 505 mit einer vorzeichenabhängigen Wahl des Einspeisepunkts für den skalierten Einspeisestrom Ic in einen Sensor 507 der Sensoranordnung 500. In dem in Fig. 5 gezeigten Ausführungsbeispiel ist der Sensor 507 als ein Sensor in Brückenschaltung ausgeführt.

Des Weiteren weist die Sensoranordnung 500 einen Ausgangsverstärker 517 (auch bezeichnet als Amp) mit einem differenziellen Eingang auf.

Ferner weist die Sensoranordnung 500 einen Versorgungsregler 540 auf.

Da das Sensorelement 507 ein Sensor in Brückenschaltung ist, weist das Ersatzschaltbild des Sensorelements mehrere Einzelwiderstände auf, welche in Abhängigkeit von dem Einspeisepunkt für den Sensor 507 für das jeweilige Signal, das in diesem Einspeisepunkt eingespeist wird, den Innenwiderstand des Sensorelements 507 bilden. Idealerweise ändern sich bei Störeinflüssen alle Widerstände des Sensors 507 in Brückenschaltung gleichgerichtet.

Der Fußpunktregler 401 ist ausgebildet, um an dem Sensorelement 507 eine Fußpunktspannung Vfp bereitzustellen, um ansprechend auf die Änderung des Innenwiderstands des Sensorelements 507 dessen Speisestrom Isupply so zu verändern, dass die Fußpunktspannung Vfp in einem vorgegebenen Bereich (beispielsweise innerhalb eines Toleranzbereichs konstant) bleibt und um innerhalb eines Toleranzbereichs den Einspeisestrom I2 (auch bezeichnet als Igm2) proportional zu dem Speisestrom Isupply einzustellen.

Der Versorgungsregler 540 stellt eine Versorgungsspannung bereit (Vssupply + Vfp) und wirkt weiterhin als Stromquelle für den Speisestrom Isupply. Der Fußpunktregler 401 wirkt als Stromsenke für den Speisestrom Isupply.

Die Speisespannung Vssupply an dem Sensorelement 507 entspricht einer Differenz zwischen der Sensorspannung (die von dem Versorgungsregler 540 bereitgestellt wird) und der Fußpunktspannung Vfp.

Der Fußpunktregler 401 und der Versorgungsregler 540 ändern bei der Änderung des Innenwiderstands des Sensorelements 507 im Zusammenspiel den Speisestrom Isupply derart, dass die Speisespannung Vssupply für das Sensorelement in dem vorgegebenen Bereich bleibt. Ferner ist der Fußpunktregler 401 ausgebildet, um den Einspeisestrom I2 in Abhängigkeit von dem Speisestrom Isupply einzustellen und um Änderungen des Speisestroms Isupply auf den Einspeisestrom I2 zu übertragen.

Weiterhin können der Fußpunktregler 401 und der Versorgungsregler 540 ausgebildet sein, um ansprechend auf die Änderung des Innenwiderstands des Sensorelements 507 den Speisestrom Isupply so zu verändern, dass die Sensorspannung und die Fußpunktspannung Vfp in für sie vorgegebenen Bereichen bleiben. Mit anderen Worten können der Versorgungsregler 540 und der Fußpunktregler 401 die Spannungen die sie bereitstellen, so regeln, dass diese konstant bleiben, so dass über dem Sensorelement 507 eine konstante Spannung Vssupply abfällt.

Wie in Fig. 5 gezeigt, kann der Fußpunktregler 401 einen Regelverstärker 321 mit Stromausgang (auch bezeichnet als OTA), einen Kondensator 322 und einen Strombereitsteller 323 (in Form einer matched gm-Stufe) aufweisen. Der Regelverstärker 321 ist ausgebildet, um ein Differenzsignal Vcrl2 bereitzustellen, welches eine Abweichung der Fußpunktspannung Vfp von einer Sollspannung Vsollfp beschreibt. Die Sollspannung Vsollfp kann beispielsweise von einer temperaturstabilen Referenzspannungsquelle 111 bereitgestellt werden.

Ferner kann der Strombereitsteller 323 ausgebildet sein, um basierend auf dem Referenzsignal Vctl2 den Einspeisestrom I2 derart bereitzustellen, dass eine Änderung des Einspeisestroms I2 innerhalb eines Toleranzbereichs proportional zu einer Änderung des Speisestroms Isupply ist. Hierbei ist zu beachten, dass der Toleranzbereich sich unter anderem auch dadurch ergibt, dass der Strombereitsteller 323 als Basis für die Einstellung des Einspeisestrom I2 nicht nur den Speisestrom Isupply, sondern den Speisestrom Isupply plus den skalierten Einspeisestrom Ic empfängt.

Wie in Fig. 5 gezeigt, können weiterhin der skalierte Einspeisestrom Ic und der Speisestrom Isupply an zueinander verschiedenen Anschlüssen des Sensorelements 507 eingespeist werden. So speist der Versorgungsregler 540 den Speisestrom Isupply an einem ersten Anschluss 507a des Sensorelements 507 ein. Der Einspeisestromskalierer 505 kann den skalierten Einspeisestrom Ic wahlweise (in Abhängigkeit eines Vorzeichens für den skalierten Einspeisestrom Ic) an einem zweiten Anschluss 507b oder einem dritten Anschluss 507c des Sensorelements 507 einspeisen. Ferner kann der Fußpunktregler 401 die Fußpunktspannung Vfp an einem vierten Anschluss 507d des Sensorelements 507 bereitstellen. Ferner kann die Sensoranordnung 500 einen Skalierregler 219 (auch bezeichnet als digitaler Regler) aufweisen, welcher ausgebildet ist, um basierend auf dem Ausgangssignal VM der Sensoranordnung 500 dem Einspeisestromskalierer 505 ein Skalierungssignal bereitzustellen. Beispielsweise kann der Skalierregler 219 dem Einspeisestromskalierer 505 ein digitales Datenwort Z zur Skalierung des Einspeisestroms I2 bereitstellen und weiterhin ein Vorzeichensignal SIGN bereitstellen, welches eine Richtung des zu kompensierenden Offsetanteils in dem Ausgangssignal VM beschreibt. Der Einspeisestromskalierer 505 ist ausgebildet, um basierend auf dem Skalierungssignal den skalierten Einspeisestrom Ic so bereitzustellen, dass die in dem Sensorelement 507 abfallende Spannung Vc einem Offsetanteil in dem Ausgangssignal VM der Sensoranordnung 500 entgegenwirkt. Beispielsweise kann die Sensoranordnung 505 ausgebildet sein, um in Abhängigkeit von dem Vorzeichensignal SIGN einen Einspeisepunkt für den skalierten Einspeisestrom Ic an dem Sensorelement 507 zu wählen. Beispielsweise kann der Einspeisestromskalierer 505 einen Schalter 542 (auch bezeichnet als Sw) aufweisen, um den skalierten Einspeisestrom Ic in Abhängigkeit von dem Vorzeichensignal SIGN entweder an dem zweiten Anschluss 507b oder dem dritten Anschluss 507c des Sensorelements 507 einzuspeisen.

Weiterhin sind der zweite Anschluss 507b und der dritte Anschluss 507c mit einem differenziellen Eingang des Ausgangsverstärkers 517 gekoppelt, so dass das Ausgangssignal VM des Ausgangsverstärkers 517 eine Differenz der Signale zwischen diesen Anschlüssen 507b und 507c des Sensorelements 507 beschreibt. An diesen Anschlüssen 507b oder 507c prägt auch der Einspeisestromskalierer 505 (in Abhängigkeit von dem Vorzeichensignal SIGN) den skalierten Einspeisestrom Ic ein.

Mit anderen Wort ist der Einspeisestromskalierer 505 ausgebildet, um den skalierten Einspeisestrom Ic an einem Anschluss 507b, 507c des Sensorelements 507 in das Sensorelement einzuprägen, an dem auch von dem Sensorelement 507 ein Sensorsignal oder zumindest ein (differenzieller) Teil des Sensorsignals bereitgestellt wird, um einen in dem Sensorsignal vorhandenen Offset (beispielsweise den Sensoroffset VOS und den Verstärkeroffset VOA) zu reduzieren.

Der Einspeisestromskalierer 505 kann einen Stromteiler 327, eine Stromsenke 329 und einen Stromspiegel 531 (auch bezeichnet als MIRR2) aufweisen. Der Einspeisestromskalierer 505 ist daher ähnlich dem Einspeisestromskalierer oder DAC 205, wie er in Fig. 3 gezeigt ist, mit dem Unterschied, dass der Stromspiegel 531 keinen Vorzeicheneingang benötigt, da die Richtung des skalierten Einspeisestroms Ic durch Wahl des Einspeisepunkts an dem Sensor 507 gewählt wird.

Im Folgenden soll die Funktionsweise der in Fig. 5 gezeigten Sensoranordnung 500 detailliert beschrieben werden.

Ist im System ein Fußpunktregler vorhanden, der die Spannung Vfp zwischen Sensor und VSS regelt, dann kann das Steuersignal für die Ausgangsstufe dieses Regelkreises eine zweite Ausgangsstufe ansteuern, die den Strom Igm2 generiert. Da der zur Einstellung einer konstanten Spannung an Rs benötigte Strom Isupply von Rs (T) abhängt, ist ein um Kgm kleinerer Strom als Isupply der optimale Strom, um an Rs eine Kompensationsspannung Vc zu generieren. Gemäß weiteren Ausführungsbeispielen kann der Strom auch vom Versorgungsregler abgeleitet werden.

Der zu den bereits vorhandenen Teilen zusätzlich notwendige Aufwand an Schaltung wird kleiner als im Ausführungsbeispiel 300 und die Schaltung bleibt sehr rauscharm.

Sensor kann ein resistiver Sensor in Brückenschaltung oder z.B. ein Hallelement sein. Dann kann das Vorzeichen des generierten Offsets mit dem SIGN-Signal einfach durch Umschalten des Einspeisepunkts von Ic von INP nach INN realisiert werden.

Amp ist ein Differenzverstärker, der gemäß weiteren Ausführungsbeispielen auch einen differenziellen Ausgang haben kann, statt dem in Fig. 5 gezeigten unipolaren Ausgang, an dem VM gegen VSS (Bezugspotential, beispielsweise Massepotential) ansteht.

Der Versorgungsregler und der Fußpunktregler stellen die Spannung am Sensor Vssupply konstant ein. Dann ist der Versorgungsstrom des Sensors mit einem Zweigwiderstand von 2*Rs

$$\text{Isupply} = \text{Vssupply} / (2 * \text{Rs}(T)) \tag{11}$$

Da Isupply vom Regler proportional zu Igm2 geregelt wird, ist (mit Ic=0)

$$\text{Igm2}(T) = 1/\text{Kgm} * \text{Vssupply} / (2 * \text{Rs}(T)) \tag{12}$$

Hier wird der gegenüber Isupply als klein angenommene Strom Ic vernachlässigt, denn das Ergebnis wird dann unwesentlich verändert, wenn an dieser Stelle Isupply + Ic berücksichtigt wird.

$$\text{Idiv}(T) = 1/\text{Kgm} * \text{Vssupply} / (2 * \text{Rs}(T)) * Z/2^N ; Z = [0, 1, ... , 2^N\text{-}1] \tag{13}$$

Der zweite Stromspiegel MIRR2 mit einem Spiegelverhältnis K2, das wiederum nahe an 1 liegen kann, leitet den Rest des Stroms Idiv als Ic an den Einspeiseumschalter Sw weiter. Das Vorzeichen wird mit dem Binärsignal SIGN eingestellt.

$$\text{Ic}(T) = +/\text{-} K2/\text{Kgm} * \text{Vssupply} / (2 * \text{Rs}(T)) * Z/2^N ; Z = [0, 1, ... , 2^N\text{-}1] \tag{14}$$

Ic sieht am Einspeisepunkt eine Impedanz Rs des Sensors, die sich aus den zwei parallel geschalteten Widerständen des Wertes 2*Rs ergibt bzw. der eingespeiste Strom Ic teilt sich gleichermaßen in die zwei Teilzweige auf. Daraus folgt:

$$\text{Vc} = \text{Rs}(T) * \text{Ic}(T) = +/\text{-} \text{Rs}(T) * K2/\text{Kgm} * \text{Vssupply} / (2 * \text{Rs}(T)) * Z/2^N$$
$$= +/\text{-} K2/\text{Kgm} * \text{Vssupply} / 2 * Z/2^N \tag{15}$$

Dabei kürzt sich Rs(T) wieder und die im Sensor generierte Spannung Vc ist wieder unabhängig vom Sensorinnenwiderstand und damit auch von dessen Temperaturgang. Sie hängt nur noch ab von der Betriebsspannung des Sensors und dem digitalen Reglerwert Z. Da die zu kompensierende Offsetspannung mit der Versorgungsspannung des Sensors skaliert, ist diese Betriebsweise von Vorteil.

Die Einstellauflösung ΔVc ist:

$$\Delta\text{Vc} = K2/\text{Kgm} * \text{Vssupply} / 2 * 1/2^N \tag{16}$$

Mit der Einstellung

$$Vc\,(T) = (-1/2 \ldots +1/2) * \Delta Vc - [\,Vos(T) + Voa(T)\,] \qquad (17)$$

bleibt wiederum nur noch der Nutzanteil und ein Rest des Offsets übrig.

Die Ausgangsspannung ist dann

$$Vout = Gv * Vs + Gv * (-1/2 \ldots +1/2) * \Delta Vc$$
$$= Gv * Vs + Gv * (-1/2 \ldots +1/2) * K2/Kgm * Vssupply / 2 * 1/2^N \qquad (18)$$

K2 kann wiederum nahe 1 liegen, dann legt Kgm die Größe des maximal einspeisbaren Signals fest. Der Faktor $1/2^N$ legt die Auflösung fest. Die Spannung am Sensor wird automatisch berücksichtigt.

Die Schaltung ist Rauscharm und ermöglicht durch eine kleine Einstellauflösung ΔVc eine hohe Verstärkung Gv.

Gemäß weiteren Ausführungsbeispielen kann auch der Versorgungsregler 540 ausgebildet sein, um den Einspeisestrom I2 bereitzustellen, der Fußpunktregler 401 bräuchte dann den Einspeisestrom I2 nicht mehr bereitzustellen. Ein Vorteil hiervon wäre, dass der Versorgungsregler 540, als Basis für die Regelung des Einspeisestroms I2 nicht mehr die Summe aus dem Speisestrom Isupply und dem skalierten Einspeisestrom Ic (Isupply + Ic) hat, sondern nur noch den Speisestrom Isupply, wodurch eine bessere Proportionalität zwischen dem Speisestrom Isupply und dem Einspeisestrom I2 erreicht werden könnte.

Mit anderen Worten kann der Spannungsregler auch ein Versorgungsregler sein, und ausgebildet sein, um an dem Sensorelement 507 eine Sensorspannung bereitzustellen, und um ansprechend auf die Änderung des Innenwiderstands des Sensorelements 507 dessen Speisestrom Isupply so zu verändern, dass die Sensorspannung Vssupply in einem vorgegebenen Bereich bleibt und um innerhalb eines Toleranzbereichs den Einspeisestrom *I2 proportional zu dem Speisestrom Isupply einzustellen bzw. bereitzustellen.

Zusätzlich kann dann auch noch ein Fußpunktregler existieren, der die Fußpunktspannung Vfp bereitstellt, beispielsweise so, dass der Fußpunktregler und der Versorgungsregler bei der Änderung des Innenwiderstands des Sensorelements im Zusammenspiel den Speisestrom Isupply derart ändern, dass die Speisespannung Vssupply für das Sensorelement in dem vorgegebenen Bereich bleibt. Der Versorgungsregler kann ausgebildet sein, um den Einspeisestrom I2 in Abhängigkeit von dem Speisestrom Isupply einzustellen und um Änderungen des Speisestrom Isupply auf den skalierten Einspeisestrom Ic zu übertragen.

Zusammenfassend zeigt Fig. 5 ein Ausführungsbeispiel, bei differenziellem Sensor mit Fußpunktregelung.

Der in Fig. 5 gezeigte Sensor in Brückenschaltung kann gemäß weiteren Ausführungsbeispiele auch in den in Fig. 1 bis 3 gezeigten Sensoranordnungen verwendet werden.

Insbesondere kann das in Fig. 5 gezeigte System in einem sogenannten Spinning Current-Verfahren speziell mit Hallsensoren verwendet werden. So kann die Sensoranordnung 505 beispielsweise ausgebildet sein, um den skalierten Einspeisestrom Ic zeitlich aufeinanderfolgend an jedem der vier Anschlüsse 507a bis 507d des Sensorelements 507 bereitzustellen, um bei jeder Messung mit dem Sensorelement 507 den Offsetanteil in dem Ausgangssignal VM der Sensoranordnung 500 zu reduzieren.

Im Folgenden sollen noch einige Aspekte von Ausführungsbeispielen zusammengefasst werden.

Ausführungsbeispiele ermöglichen eine Aufbereitung von Sensorsignalen Offset-behafteter Sensoren mit auch Ohmschen Innenwiderstand. Die Anordnung kann so ausgelegt werden, dass der begrenzende Faktor der Messwerterfassung nur noch die stochastische Störungen des Sensors selber sind und dass sich mit Ausführungsbeispielen der vorliegenden Erfindung eine genaue und rauscharme Kompensation des Offsets von Sensor und Verstärker noch vor dem Verstärker erzielen lassen.

Im Gegensatz zu den eingangs erwähnten Verfahren der Offsetkompensation durch Addition/Subtraktion eines digital geregelten Signals nach dem Verstärker benötigen Ausführungsbeispiele keine Kompensationseinrichtung am Ausgang, da die Kompensation am Eingang das gewünschte Ergebnis erreicht.

Im Gegensatz zu den eingangs erwähnten Konzepten mit einer Offsetkompensation durch Addition bzw. Subtraktion eines digital geregelten Signals vor dem Verstärker wird bei Ausführungsbeispielen der vorliegenden Erfindung das Kompensationssignal direkt im Sensor erzeugt und benötigt deshalb keine Summiererschaltung. Das Sensorsignal bleibt dadurch so gut wie unbeeinflusst.

Im Gegensatz zu den eingangs erwähnten Konzepten der Offsetkompensation im Sensor durch feste Einspeisung eines temperaturabhängigen Stroms wird bei Ausführungsbeispielen ein temperaturabhängiger und digital nachgeregelter Strom zur Offsetkompensation eingespeist.

Die in den Fig. 1 bis 5 gezeigten Sensorelemente bzw. Sensoren können beispielsweise Hallsensoren, beispielsweise in Brückenschaltung sein.

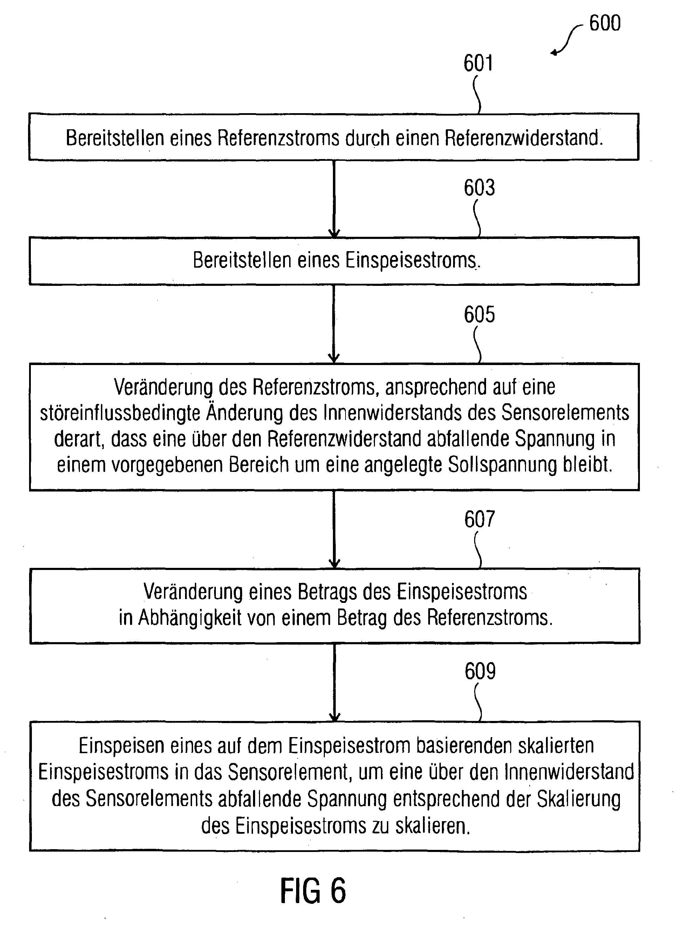

Fig. 6 zeigt ein Verfahren 600 bei einer Sensoranordnung mit einem Sensorelement, das einen Innenwiderstand aufweist.

Das Verfahren 600 weist einen Schritt 601 des Bereitstellens eines Referenzstroms durch einen Referenzwiderstand auf.

Ferner weist das Verfahren 600 einen Schritt 603 des Bereitstellens eines Einspeisestroms auf.

Ferner umfasst das Verfahren 600 einen Schritt 605 des Veränderns des Referenzstroms, ansprechend auf eine störeinflussbedingte Änderung des Innenwiderstands des Sensorelements derart, dass eine über den Referenzwiderstand abfallende Spannung in einem vorgegebenen Bereich um eine angelegte Sollspannung bleibt.

Ferner weist das Verfahren 600 einen Schritt 607 des Veränderns eines Betrags des Einspeisestroms in Abhängigkeit von einem Betrag des Referenzstroms auf.

Ferner umfasst das Verfahren 600 einen Schritt 609 des Einspeisens eines auf dem Einspeisestrom basierenden skalierten Einspeisestroms in das Sensorelement, um eine über den Innenwiderstand des Sensorelements abfallende Spannung entsprechend der Skalierung des Einspeisestroms zu skalieren. Der Referenzwiderstand und der Innenwiderstand weisen dabei ein vorgegebenes Verhältnis zueinander auf.

Das Verfahren 600 kann beispielsweise mit einer der Sensoranordnungen 100-300 ausgeführt werden.

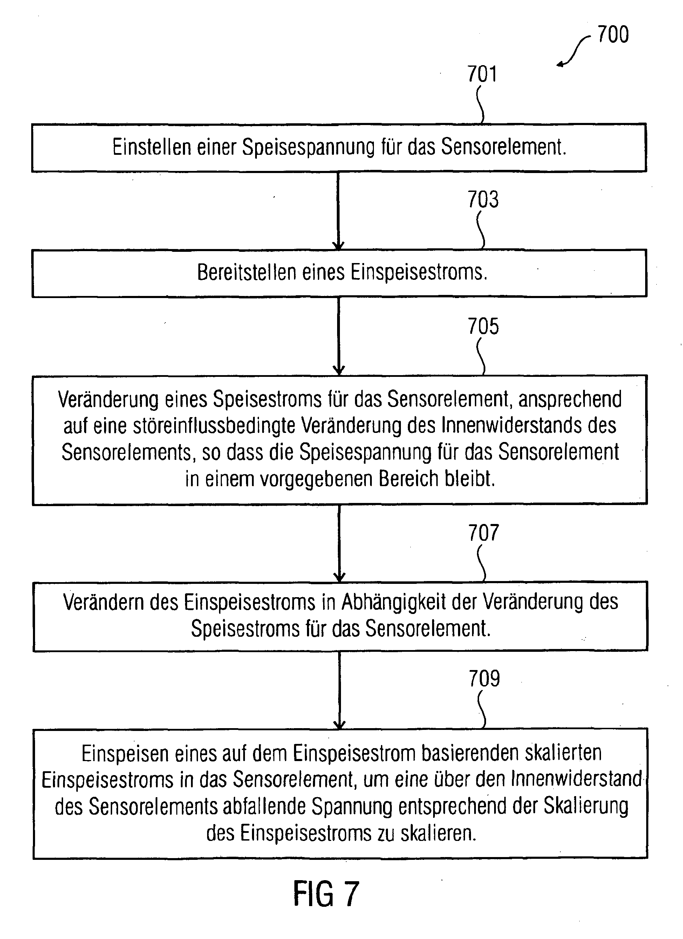

Fig. 7 zeigt ein Verfahren 700 bei einer Sensoranordnung mit einem Sensorelement, das einen Innenwiderstand aufweist.

Das Verfahren 700 weist einen Schritt 701 des Einstellens einer Speisespannung für das Sensorelement auf.

Weiterhin weist das Verfahren 700 einen Schritt 703 des Bereitstellens eines Einspeisestroms auf.

Weiterhin umfasst das Verfahren 700 einen Schritt 705 des Veränderns eines Speisestroms für das Sensorelement, ansprechend auf eine störeinflussbedingte Veränderung des Innenwiderstands des Sensorelements, so dass die Speisespannung für das Sensorelement in einem vorgegebenen Bereich bleibt.

Weiterhin umfasst das Verfahren 700 einen Schritt 707 des Veränderns des Einspeisestroms in Abhängigkeit der Veränderung des Speisestroms für das Sensorelement.

Weiterhin umfasst das Verfahren 700 einen Schritt 709 des Einspeisens eines auf dem Einspeisestrom basierenden skalierten Einspeisestroms in das Sensorelement, um eine über den Innenwiderstand des Sensorelements abfallende Spannung entsprechend der Skalierung des Einspeisestroms zu skalieren.

Das Verfahren 700 kann beispielsweise mit einer der Sensoranordnungen 400 und 500 ausgeführt werden.

Gemäß einem ersten Aspekt umfasst eine Sensoranordnung 100, 200, 300, einen Stromregler 101, 301; einen Referenzwiderstand 103, Rref; einen Einspeisestromskalierer 105, 205; und ein Sensorelement 107, 207 mit einem Innenwiderstand 109 Rs, wobei der Innenwiderstand 109, Rs des Sensorelements 107, 207 und der Referenzwiderstand 103, Rref ein vorgegebenes Verhältnis zueinander aufweisen; wobei der Stromregler 101, 301 ausgebildet ist, um einen Referenzstrom I1, Iref durch den Referenzwiderstand 103, Rref bereitzustellen und um ansprechend auf eine störeinflussbedingte Veränderung des Referenzwiderstands den Referenzstrom I1, Iref so zu verändern, dass die über den Referenzwiderstand 103, Rref abfallende Spannung VR in einem vorgegebenen Bereich um eine angelegte Sollspannung Vsoll bleibt; wobei der Stromregler 101, 301 ferner ausgebildet ist, dem Einspeisestromskalierer 105, 205 einen Einspeisestrom I2, Igm2 bereitzustellen und um einen Betrag des Einspeisestroms I2, Igm2 in Abhängigkeit von einem Betrag des Referenzstroms I1, Iref, Igm1 zu verändern; und wobei der Einspeisestromskalierer 105, 205 ausgebildet ist, um basierend auf dem Einspeisestrom I2, Igm2 einen skalierten Einspeisestrom Ic in das Sensorelement 107, 207 einzuspeisen, um eine über den Innenwiderstand 109Rs des Sensorelements 107. 207 abfallende Spannung Vc entsprechend der Skalierung des Einspeisestroms I2 zu skalieren.

Gemäß einem zweiten Aspekt unter Rückbezug auf den ersten Aspekt ist der Stromregler 101, 301 ausgebildet, um den Betrag des Einspeisestroms I2 proportional zum Betrag des Referenzstroms I1 zu verändern, in einem Verhältnis, das sich ergibt aus dem Verhältnis zwischen Referenzwiderstand 103 und Innenwiderstand 109 des Sensorelements 107, 207 und aus einem Verhältnis zwischen der Sollspannung Vsoll und einer, bei keiner oder minimalen Skalierung des Einspeisestroms I2 abfallenden Spannung Vc über den Innenwiderstand 109.

Gemäß einem dritten Aspekt unter Rückbezug auf zumindest einen des ersten bis zweiten Aspekts ist der Referenzwiderstand 103 so ausgebildet, dass bestimmte Störeinflüsse, die Änderungen des Innenwiderstands 109 des Sensorelements 107, 207 bewirken, im entsprechenden Verhältnis die Größe des Referenzwiderstandes 103 ändern, so dass die über den Innenwiderstand 109 des Sensorelements 107, 207 abfallende Spannung Vc innerhalb eines Toleranzbereiches unabhängig von diesen Störeinflüssen ist.

Gemäß einem vierten Aspekt unter Rückbezug auf zumindest einen des ersten bis dritten Aspekts sind der Stromregler 101, 301 und der Referenzwiderstand 103 ausgebildet, um die Veränderung des Einspeisestroms I2 so durchzuführen, dass bei der störeinflussbedingten Änderung des Referenzwiderstands 103 und einer damit einhergehenden störeinflussbedingten Änderung des Innenwiderstands 109 des Sensorelements 107, 207 die über den Innenwiderstand 109 abfallende Spannung Vc in einem vorgegebenen Bereich bleibt.

Gemäß einem fünften Aspekt unter Rückbezug auf zumindest einen des ersten bis vierten Aspekts ist die Sensoranordnung 100, 200, 300 ausgebildet, um die über den Innenwiderstand 109 des Sensorelements 107, 207 abfallende Spannung Vc derart zu erzeugen, dass diese einem Offsetanteil in einem Ausgangssignal VM der Sensoranordnung 100, 200, 300 entgegenwirkt.

Gemäß einem sechsten Aspekt unter Rückbezug auf zumindest einen des ersten bis fünften Aspekts weisen ein Material des Referenzwiderstands 103 und ein Material des Innenwiderstands 109 innerhalb eines Toleranzbereichs dasselbe Verhalten gegenüber einem Störeinfluss auf derart, dass eine durch einen Störeinfluss hervorgerufene Änderung des Referenzwiderstands 103 eine gleichgerichtete und entsprechend dem Verhältnis zwischen dem Referenzwiderstand 103 und dem Innenwiderstand 109 des Sensorelements 107, 207 skalierte Änderung des Innenwiderstands 109 des Sensorelements 107, 207 hervorruft.

Gemäß einem siebten Aspekt unter Rückbezug auf zumindest einen des ersten bis sechsten Aspekts skalieren Abmessungen des Referenzwiderstands 103 entsprechend dem Verhältnis zwischen dem Referenzwiderstand 103 und dem Innenwiderstand 109 des Sensorelements 107, 207 mit Abmessungen des Innenwiderstands 109 des Sensorelements 107, 207.

Gemäß einem achten Aspekt unter Rückbezug auf zumindest einen des ersten bis siebten Aspekts ist der Referenzwiderstand 103 ausgebildet, sodass sein Widerstandswert eine temperaturbedingte Änderung des Innenwiderstands 109 des Sensorelements 107, 207 entsprechend dem Verhältnis zwischen dem Referenzwiderstand 103 und dem Innenwiderstand 109 des Sensorelements 107, 207 erfährt.

Gemäß einem neunten Aspekt unter Rückbezug auf zumindest einen des ersten bis achten Aspekts weist die Sensoranordnung 100, 200, 300 ferner eine temperaturstabile Referenzspannungsquelle 111 zur Erzeugung der Sollspannung Vsoll auf und der Stromregler 101, 301 ist ausgebildet, um den Referenzstrom I1 so zu regeln, dass die Spannung VR über dem Referenzwiderstand 103 innerhalb eines vorgegebenen Toleranzbereichs der Sollspannung Vsoll entspricht.

Gemäß einem zehnten Aspekt unter Rückbezug auf zumindest einen des ersten bis neunten Aspekts weist der Stromregler 301 einen Regelverstärker 321 und einen Strombereitsteller 323, 325 auf; wobei der Regelverstärker 321 ausgebildet ist, um ein Differenzsignal Vctl1 bereitzustellen, welches eine Abweichung der über den Referenzwiderstand 103 abfallenden Spannung VR von der Sollspannung Vsoll beschreibt; und wobei der Strombereitsteller 323, 325 ausgebildet ist, um basierend auf dem Differenzsignal Vct11 den Referenzstrom I1 und den Einspeisestrom I2 bereitzustellen derart, dass der Einspeisestrom I2 proportional zu dem Referenzstrom I1 ist.

Gemäß einem elften Aspekt weist eine Sensoranordnung 400, 500, folgende Merkmale auf: einen Spannungsregler 401; einen Einspeisestromskalierer 105, 505; und ein Sensorelement 107, 507 mit einem Innenwiderstand 109, Rs; wobei der Spannungsregler 401 ausgebildet ist, um eine Speisespannung Vssupply für das Sensorelement 107, 507 einzustellen und um ansprechend auf eine störeinflussbedingte Veränderung des Innenwiderstands 109, Rs des Sensorelements 107, 507 einen Speisestrom Isupply des Sensorelements 107, 507 so zu verändern, dass die Speisespannung Vssupply für das Sensorelement 107, 507 in einem vorgegeben Bereich bleibt; wobei der Spannungsregler 401 ferner ausgebildet ist, um dem Einspeisestromskalierer 105, 505 einen Einspeisestrom I2, Igm2 bereitzustellen und um diesen Einspeisestrom I2, Igm2 in Abhängigkeit der Veränderung des Speisestroms Isupply für das Sensorelement 107, 507 zu ändern; und wobei der Einspeisestromskalierer 105, 505 ausgebildet ist, um basierend auf dem Einspeisestrom I2, Igm2 einen skalierten Einspeisestrom Ic in das Sensorelement 107, 507 einzuspeisen, um eine über den Innenwiderstand 109, Rs des Sensorelements 107, 507 abfallende Spannung Vc entsprechend der Skalierung des Einspeisestroms 12, Igm2 zu skalieren.

Gemäß einem zwölften Aspekt unter Rückbezug auf den elften Aspekt ist der Spannungsregler 401 ausgebildet, um den Einspeisestrom I2 so einzustellen, dass eine Änderung des Einspeisestroms 12 innerhalb eines Toleranzbereiches proportional zu einer Änderung des Speisestroms Isupply ist.

Gemäß einem dreizehnten Aspekt unter Rückbezug auf zumindest einen des elften bis zwölften Aspekts ist der Spannungsregler 401 ein Fußpunktregler 401 und ausgebildet, um an dem Sensorelement 507 eine Fußpunktspannung Vfp bereitzustellen, um ansprechend auf die Änderung des Innenwiderstands des Sensorelements 507 dessen Speisestrom Isupply so zu verändern, dass die Fußpunktspannung Vfp in einem vorgegebenen Bereich bleibt und um innerhalb eines Toleranzbereiches den Einspeisestrom I2 proportional zu dem Speisestrom Isupply einzustellen.

Gemäß einem vierzehnten Aspekt unter Rückbezug auf den dreizehnten Aspekt weist die Sensoranordnung 500 ferner einen Versorgungsregler 540 auf, der ausgebildet ist, um an dem Sensorelement 507 eine Sensorspannung bereitzustellen und der als Stromquelle für den Speisestrom Isupply wirkt; wobei der Fußpunktregler 401 als Stromsenke für den Speisestrom Isupply wirkt; wobei die Speisespannung Vssupply einer Differenz zwischen der Sensorspannung und der Fußpunktspannung Vfp entspricht; wobei der Fußpunktregler 401 und der Versorgungsregler 540 bei der Änderung des Innenwiderstands des Sensorelements 507, im Zusammenspiel den Speisestrom Isupply derart ändern, dass die Speisespannung Vssupply für das Sensorelement 507 in dem vorgegebenen Bereich bleibt; und wobei der Fußpunktregler 401 ausgebildet ist, um den Einspeisestrom I2 in Abhängigkeit von dem Speisestrom Isupply einzustellen und um Änderungen des Speisestroms Isupply auf den Einspeisestrom I2 zu übertragen.

Gemäß einem fünfzehnten Aspekt unter Rückbezug auf zumindest einen des elften bis zwölften Aspekts ist der Spannungsregler ein Versorgungsregler und ausgebildet, um an dem Sensorelement eine Sensorspannung bereitzustellen, um ansprechend auf die Änderung des Innenwiderstands des Sensorelements dessen Speisestrom so zu verändern, dass die Sensorspannung in einem vorgegebenen Bereich bleibt und um innerhalb eines Toleranzbereiches den Einspeisestrom proportional zu dem Speisestrom einzustellen.

Gemäß einem sechzehnten Aspekt unter Rückbezug auf den fünfzehnten Aspekt weist die Sensoranordnung ferner einen Fußpunktregler auf, der ausgebildet ist, um an dem Sensorelement eine Fußpunktspannung bereitzustellen und der als Stromsenke für den Speisestrom wirkt; wobei der Versorgungsregler als Stromquelle für den Speisestrom wirkt; wobei die Speisespannung einer Differenz zwischen der Sensorspannung und der Fußpunktspannung entspricht; wobei der Fußpunktregler und der Versorgungsregler bei der Änderung des Innenwiderstands des Sensorelements, im Zusammenspiel den Speisestrom derart ändern, dass die Speisespannung für das Sensorelement in dem vorgegebenen Bereich bleibt; und wobei der Versorgungsregler ausgebildet ist, um den Einspeisestrom in Abhängigkeit von dem Speisestrom einzustellen und um Änderungen des Speisestroms auf den Einspeisestrom zu übertragen.

Gemäß einem siebzehnten Aspekt unter Rückbezug auf zumindest einen des vierzehnten bis sechzehnten Aspekts sind der Fußpunktregler 401 und der Versorgungsregler 540 ausgebildet, um ansprechend auf die Änderung des Innenwiderstands des Sensorelements 507 den Speisestrom I2 so zu verändern, dass die Sensorspannung und die Fußpunktspannung Vfp in für sie vorgegeben Bereichen bleiben.

Gemäß einem achzehnten Aspekt unter Rückbezug auf zumindest einen des dreizehnten bis siebzehnten Aspekts weist der Versorgungsregler oder der Fußpunktregler 401, der den Einspeisestrom I2 bereitstellt, einen Regelverstärker 321 und einen Strombereitsteller 323 auf; wobei der Regelverstärker 321 ausgebildet ist, um ein Differenzsignal Vctrl2 bereitzustellen, welches eine Abweichung der Fußpunktspannung Vfp oder der Sensorspannung von einer Sollspannung Vsollfp beschreibt; und wobei der Strombereitsteller 323 ausgebildet ist, um basierend auf dem Differenzsignal Vctrl2 den Einspeisestrom I2 bereitzustellen derart, dass eine Änderung des Einspeisestroms I2 innerhalb eines Toleranzbereiches proportional zu einer Änderung des Speisestroms Isupply ist.

Gemäß einem neunzehnten Aspekt unter Rückbezug auf zumindest einen des elften bis achzehnten Aspekts ist die Sensoranordnung 500 ausgebildet, um den Speisestrom Isupply und den skalierten Einspeisestrom Ic an zueinander verschiedenen Anschlüssen 507a, 507b, 507c des Sensorelements 507 bereitzustellen.

Gemäß einem zwanzigsten Aspekt unter Rückbezug auf zumindest einen des ersten bis neunzehnten Aspekts weist die Sensoranordnung 500 ferner einen Skalierregler 219 auf; wobei der Skalierregler 219 ausgebildet ist, um basierend auf einem Ausgangssignal VM der Sensoranordnung 500 dem Einspeisestromskalierer 505 ein Skalierungssignal Z, SIGN bereitzustellen; wobei der Einspeisestromskalierer 505 ausgebildet ist, um basierend auf dem Skalierungssignal Z, SIGN den skalierten Einspeisestrom Ic so bereitzustellen, dass die in dem Sensorelement abfallende Spannung Vc einem Offsetanteil in dem Ausgangssignal VM der Sensoranordnung 500 entgegenwirkt.

Gemäß einem einundzwanzigsten Aspekt unter Rückbezug auf den zwanzigsten Aspekt weist die Sensoranordnung 500 ferner einen Ausgangsverstärker 517 auf zum Bereitstellen des Ausgangssignals VM in Abhängigkeit von einem Sensorsignal des Sensorelements 507; wobei der Skalierregler 219 das Skalierungssignal ZSIGN in Abhängigkeit von einem Sensoroffset VOS und einem Ausgangsverstärkeroffset VOA bereitstellt derart, dass die über den Innenwiderstand des Sensorelements 507 abfallende Spannung Vc sowohl dem Sensoroffset VOS als auch dem Ausgangsverstärkeroffset VOA entgegenwirkt.

Gemäß einem zweiundzwanzigsten Aspekt unter Rückbezug auf zumindest einen des zwanzigsten bis einundzwanzigsten Aspekts ist das Sensorelement 507 ein Sensor 507 in Brückenschaltung oder ein Hallelement; und wobei der Einspeisestromskalierer 505 ausgebildet ist, um in Abhängigkeit von dem Skalierungssignal ZSIGN ein Vorzeichen der in dem Sensorelement 507 erzeugten Spannung Vc durch Umschalten eines Einspeisepunkts 507b, 507c an dem Sensorelement 507 für den skalierten Einspeisestrom Ic zu wählen.

Gemäß einem dreiundzwanzigsten Aspekt unter Rückbezug auf zumindest einen des ersten bis zweiundzwanzigsten Aspekts ist die Sensoranordnung 500 ausgebildet, um den skalierten Einspeisestrom Ic an einem Anschluss 507b, 507c des Sensorelements 507 in das Sensorelement 507 einzuprägen, an dem auch von dem Sensorelement 507 ein Sensorsignal oder zumindest ein Teil des Sensorsignals bereitgestellt wird, um einen in dem Sensorsignal vorhandenen Offset zu reduzieren.

Gemäß einem vierundzwanzigsten Aspekt unter Rückbezug auf zumindest einen des ersten bis dreiundzwanzigsten Aspekts weist das Sensorelement 507 vier Anschlüsse 507a-507d auf; und die Sensoranordnung 500 ist ausgebildet, um den skalierten Einspeisestrom Ic zeitlich aufeinanderfolgend an jedem der vier Anschlüsse 507a-507d des Sensorelements 507 bereitzustellen.

Gemäß einem fünfundzwanzigsten Aspekt unter Rückbezug auf zumindest einen des ersten bis vierundzwanzigsten Aspekts ist das Sensorelement 507 ein Hallsensor 507.

Gemäß einem sechsundzwanzigsten Aspekt weist ein Verfahren 600 bei einer Sensoranordnung mit einem Sensorelement das einen Innenwiderstand aufweist, folgende Schritte auf: Bereitstellen 601 eines Referenzstroms durch einen Referenzwiderstand; Bereitstellen 603 eines Einspeisestroms; Verändern 605 des Referenzstroms, ansprechend auf eine störeinflussbedingte Änderung des Innenwiderstands des Sensorelements derart, dass eine über den Referenzwiderstand abfallende Spannung in einem vorgegebenen Bereich um eine angelegte Sollspannung bleibt; Verändern 607 eines Betrags des Einspeisestroms in Abhängigkeit von einem Betrag des Referenzstroms; und Einspeisen 609 eines auf dem Einspeisestrom basierenden skalierten Einspeisestroms in das Sensorelement, um eine über den Innenwiderstand des Sensorelements abfallende Spannung entsprechend der Skalierung des Einspeisestroms zu skalieren; wobei der Referenzwiderstand und der Innenwiderstand ein vorgegebenes Verhältnis zueinander aufweisen.

Gemäß einem siebenundzwanzigsten Aspekt weist ein Verfahren 700 bei einer Sensoranordnung mit einem Sensorelement das einen Innenwiderstand aufweist, folgende Schritte auf: Einstellen 701 einer Speisespannung für das Sensorelement; Bereitstellen 703 eines Einspeisestroms; Verändern 705 eines Speisestrom für das Sensorelement, ansprechend auf eine störeinflussbedingte Veränderung des Innenwiderstands des Sensorelements, so dass die Speisespannung für das Sensorelement in einem vorgegeben Bereich bleibt; Verändern 707 des Einspeisestroms in Abhängigkeit der Veränderung des Speisestroms für das Sensorelement; und Einspeisen 709 eines auf dem Einspeisestrom basierenden skalierten Einspeisestroms in das Sensorelement, um eine über den Innenwiderstand des Sensorelements abfallende Spannung entsprechend der Skalierung des Einspeisestroms zu skalieren.

## Patentansprüche

1. Sensoranordnung (100, 200, 300), mit folgenden Merkmalen:

   einem Stromregler (101, 301);
   einem Referenzwiderstand (103, Rref);
   einem Einspeisestromskalierer (105, 205); und
   einem Sensorelement (107, 207) mit einem Innenwiderstand (109 Rs), wobei der Innenwiderstand (109, Rs) des Sensorelements (107, 207) und der Referenzwiderstand (103, Rref) ein vorgegebenes Verhältnis zueinander aufweisen;
   wobei der Stromregler (101, 301) ausgebildet ist, um einen Referenzstrom (I1, Iref) durch den Referenzwiderstand (103, Rref) bereitzustellen und um ansprechend auf eine störeinflussbedingte Veränderung des Referenzwiderstands den Referenzstrom (I1, Iref) so zu verändern, dass die über den Referenzwiderstand (103, Rref) abfallende Spannung (VR) in einem vorgegebenen Bereich um eine angelegte Sollspannung (Vsoll) bleibt;
   wobei der Stromregler (101, 301) ferner ausgebildet ist, dem Einspeisestromskalierer (105, 205) einen Einspeisestrom (I2, Igm2) bereitzustellen und um einen Betrag des Einspeisestroms (I2, Igm2) in Abhängigkeit von einem Betrag des Referenzstroms (I1, Iref, Igm1) zu verändern; und
   wobei der Einspeisestromskalierer (105, 205) ausgebildet ist, um basierend auf dem Einspeisestrom (I2, Igm2) einen skalierten Einspeisestrom (Ic) in das Sensorelement (107, 207) einzuspeisen, um eine über den Innenwiderstand (109Rs) des Sensorelements (107. 207) abfallende Spannung (Vc) entsprechend der Skalierung des Einspeisestroms (I2) zu skalieren.

2. Sensoranordnung (100, 200, 300) gemäß Anspruch 1,
   wobei der Stromregler (101, 301) ausgebildet ist, um den Betrag des Einspeisestroms (I2) proportional zum Betrag des Referenzstroms (I1) zu verändern, in einem Verhältnis, das sich ergibt aus dem Verhältnis zwischen Referenzwiderstand (103) und Innenwiderstand (109) des Sensorelements (107, 207) und aus einem Verhältnis zwischen der Sollspannung (Vsoll) und einer, bei keiner oder minimalen Skalierung des Einspeisestroms (I2) abfallenden Spannung (Vc) über den Innenwiderstand (109).

3. Sensoranordnung (100, 200, 300) gemäß Anspruch 1 oder 2,
   wobei der Referenzwiderstand (103) so ausgebildet ist, dass bestimmte Störeinflüsse, die Änderungen des Innenwiderstands (109) des Sensorelements (107, 207) bewirken, im entsprechenden Verhältnis die Größe des Referenzwiderstandes (103) ändern, so dass die über den Innenwiderstand (109) des Sensorelements (107, 207) abfallende Spannung (Vc) innerhalb eines Toleranzbereiches unabhängig von diesen Störeinflüssen ist.

4. Sensoranordnung (100, 200, 300) gemäß einem der Ansprüche 1 bis 3,
   wobei der Stromregler (101, 301) und der Referenzwiderstand (103) ausgebildet sind, um die Veränderung des Einspeisestroms (I2) so durchzuführen, dass bei der störeinflussbedingten Änderung des Referenzwiderstands (103) und einer damit einhergehenden störeinflussbedingten Änderung des Innenwiderstands (109) des Sensorelements (107, 207) die über den Innenwiderstand (109) abfallende Spannung (Vc) in einem vorgegebenen Bereich bleibt.

5. Sensoranordnung (100, 200, 300) gemäß einem der Ansprüche 1 bis 4,

die ausgebildet ist, um die über den Innenwiderstand (109) des Sensorelements (107, 207) abfallende Spannung (Vc) derart zu erzeugen, dass diese einem Offsetanteil in einem Ausgangssignal (VM) der Sensoranordnung (100, 200, 300) entgegenwirkt.

6. Sensoranordnung (100, 200, 300) gemäß einem der Ansprüche 1 bis 5,
   die ferner eine temperaturstabile Referenzspannungsquelle (111) zur Erzeugung der Sollspannung (Vsoll) aufweist und bei der der Stromregler (101, 301) ausgebildet ist, um den Referenzstrom (I1) so zu regeln, dass die Spannung (VR) über dem Referenzwiderstand (103) innerhalb eines vorgegebenen Toleranzbereichs der Sollspannung (Vsoll) entspricht.

7. Sensoranordnung (300) gemäß einem der Ansprüche 1 bis 6,
   bei der der Stromregler (301) einen Regelverstärker (321) und einen Strombereitsteller (323, 325) aufweist;
   wobei der Regelverstärker (321) ausgebildet ist, um ein Differenzsignal (Vctll) bereitzustellen, welches eine Abweichung der über den Referenzwiderstand (103) abfallenden Spannung (VR) von der Sollspannung (Vsoll) beschreibt;
   und wobei der Strombereitsteller (323, 325) ausgebildet ist, um basierend auf dem Differenzsignal (Vctl1) den Referenzstrom (I1) und den Einspeisestrom (I2) bereitzustellen derart, dass der Einspeisestrom (I2) proportional zu dem Referenzstrom (I1) ist.

8. Sensoranordnung (400, 500), mit folgenden Merkmalen:

   einem Spannungsregler (401);
   einem Einspeisestromskalierer (105, 505); und
   einem Sensorelement (107, 507) mit einem Innenwiderstand (109, Rs);
   wobei der Spannungsregler (401) ausgebildet ist, um eine Speisespannung (Vssupply) für das Sensorelement (107, 507) einzustellen und um ansprechend auf eine störeinflussbedingte Veränderung des Innenwiderstands (109, Rs) des Sensorelements (107, 507) einen Speisestrom (Isupply) des Sensorelements (107, 507) so zu verändern, dass die Speisespannung (Vssupply) für das Sensorelement (107, 507) in einem vorgegeben Bereich bleibt;
   wobei der Spannungsregler (401) ferner ausgebildet ist, um dem Einspeisestromskalierer (105, 505) einen Einspeisestrom (I2, Igm2) bereitzustellen und um diesen Einspeisestrom (I2, Igm2) in Abhängigkeit der Veränderung des Speisestroms (Isupply) für das Sensorelement (107, 507) zu ändern; und
   wobei der Einspeisestromskalierer (105, 505) ausgebildet ist, um basierend auf dem Einspeisestrom (I2, Igm2) einen skalierten Einspeisestrom (Ic) in das Sensorelement (107, 507) einzuspeisen, um eine über den Innenwiderstand (109, Rs) des Sensorelements (107, 507) abfallende Spannung (Vc) entsprechend der Skalierung des Einspeisestroms (I2, Igm2) zu skalieren.

9. Sensoranordnung (400, 500) gemäß Anspruch 8,
   wobei der Spannungsregler (401) ausgebildet ist, um den Einspeisestrom (I2) so einzustellen, dass eine Änderung des Einspeisestroms (I2) innerhalb eines Toleranzbereiches proportional zu einer Änderung des Speisestroms (Isupply) ist.

10. Sensoranordnung (500) gemäß einem der Ansprüche 8 bis 9,
    wobei der Spannungsregler(401) ein Fußpunktregler (401) ist und ausgebildet ist, um an dem Sensorelement (507) eine Fußpunktspannung (Vfp) bereitzustellen, um ansprechend auf die Änderung des Innenwiderstands des Sensorelements (507) dessen Speisestrom (Isupply) so zu verändern, dass die Fußpunktspannung (Vfp) in einem vorgegebenen Bereich bleibt und um innerhalb eines Toleranzbereiches den Einspeisestrom (I2) proportional zu dem Speisestrom (Isupply) einzustellen.

11. Sensoranordnung gemäß einem der Ansprüche 8 bis 9,
    wobei der Spannungsregler ein Versorgungsregler ist und ausgebildet ist, um an dem Sensorelement eine Sensorspannung bereitzustellen, um ansprechend auf die Änderung des Innenwiderstands des Sensorelements dessen Speisestrom so zu verändern, dass die Sensorspannung in einem vorgegebenen Bereich bleibt und um innerhalb eines Toleranzbereiches den Einspeisestrom proportional zu dem Speisestrom einzustellen.

12. Sensoranordnung (500) gemäß einem der Ansprüche 1 bis 11,
    ferner aufweisend einen Skalierregler (219);
    wobei der Skalierregler (219) ausgebildet ist, um basierend auf einem Ausgangssignal (VM) der Sensoranordnung (500) dem Einspeisestromskalierer (505) ein Skalierungssignal (Z, SIGN) bereitzustellen;

wobei der Einspeisestromskalierer (505) ausgebildet ist, um basierend auf dem Skalierungssignal (Z, SIGN) den skalierten Einspeisestrom (Ic) so bereitzustellen, dass die in dem Sensorelement abfallende Spannung (Vc) einem Offsetanteil in dem Ausgangssignal (VM) der Sensoranordnung (500) entgegenwirkt.

13. Sensoranordnung (500) gemäß einem der Ansprüche 1 bis 12,
die ausgebildet ist, um den skalierten Einspeisestrom (Ic) an einem Anschluss (507b, 507c) des Sensorelements (507) in das Sensorelement (507) einzuprägen, an dem auch von dem Sensorelement (507) ein Sensorsignal oder zumindest ein Teil des Sensorsignals bereitgestellt wird, um einen in dem Sensorsignal vorhandenen Offset zu reduzieren.

14. Verfahren (600) bei einer Sensoranordnung mit einem Sensorelement das einen Innenwiderstand aufweist, mit den folgenden Schritten:

Bereitstellen (601) eines Referenzstroms durch einen Referenzwiderstand;
Bereitstellen (603) eines Einspeisestroms;
Verändern (605) des Referenzstroms, ansprechend auf eine störeinflussbedingte Änderung des Innenwiderstands des Sensorelements derart, dass eine über den Referenzwiderstand abfallende Spannung in einem vorgegebenen Bereich um eine angelegte Sollspannung bleibt;
Verändern (607) eines Betrags des Einspeisestroms in Abhängigkeit von einem Betrag des Referenzstroms; und
Einspeisen (609) eines auf dem Einspeisestrom basierenden skalierten Einspeisestroms in das Sensorelement, um eine über den Innenwiderstand des Sensorelements abfallende Spannung entsprechend der Skalierung des Einspeisestroms zu skalieren;
wobei der Referenzwiderstand und der Innenwiderstand ein vorgegebenes Verhältnis zueinander aufweisen.

15. Verfahren (700) bei einer Sensoranordnung mit einem Sensorelement das einen Innenwiderstand aufweist, mit den folgenden Schritten:

Einstellen (701) einer Speisespannung für das Sensorelement;
Bereitstellen (703) eines Einspeisestroms;
Verändern (705) eines Speisestrom für das Sensorelement, ansprechend auf eine störeinflussbedingte Veränderung des Innenwiderstands des Sensorelements, so dass die Speisespannung für das Sensorelement in einem vorgegeben Bereich bleibt;
Verändern (707) des Einspeisestroms in Abhängigkeit der Veränderung des Speisestroms für das Sensorelement; und
Einspeisen (709) eines auf dem Einspeisestrom basierenden skalierten Einspeisestroms in das Sensorelement, um eine über den Innenwiderstand des Sensorelements abfallende Spannung entsprechend der Skalierung des Einspeisestroms zu skalieren.

**Claims**

1. A sensor arrangement (100, 200, 300), comprising:

a current regulator (101, 301);
a reference resistance (103, Rref);
a feed current scaler (105, 205); and
a sensor element (107, 207) having an internal resistance (109, Rs), wherein the internal resistance (109, Rs) of the sensor element (107, 207) and the reference resistance (103, Rref) comprise a predetermined ratio with respect to each other;
wherein the current regulator (101, 301) is implemented to provide a reference current (11, Iref) by the reference resistance (103, Rref) and, in response to an interference influence-conditioned change of the reference resistance, change the reference current (I1, Iref) such that the voltage (VR) decreasing across the reference resistance (103, Rref) remains in a predetermined range around an applied set voltage (Vsoll);
wherein the current regulator (101, 301) is further implemented to provide a feed current (12, Igm2) to the feed current scaler (105, 205) and to change a magnitude of the feed current (12, Igm2) depending on a magnitude of the reference current (I1, Iref, Igm1); and
wherein the feed current scaler (105, 205) is implemented, based on the feed current (12, Igm2), to supply a scaled feed current (Ic) into the sensor element (107, 207) to scale a voltage (Vc) decreasing across the internal resistance (109Rs) of the sensor element (107, 207) according to the scaling of the feed current (12).

2. The sensor arrangement (100, 200, 300) according to claim 1,
wherein the current regulator (101, 301) is implemented to change the magnitude of the feed current (I2) proportional to the magnitude of the reference current (I1) in a ratio which results from the ratio between the reference resistance (103) and the internal resistance (109) of the sensor element (107, 207) and from a ratio between the set voltage (Vsoll) and a voltage (Vc) decreasing across the internal resistance (109) with no or a minimum scaling of the feed current (I2).

3. The sensor arrangement (100, 200, 300) according to claims 1 or 2,
wherein the reference resistance (103) is implemented such that certain interference influences which cause changes of the internal resistance (109) of the sensor element (107, 207) change the magnitude of the reference resistance (103) in a corresponding ratio so that the voltage (Vc) decreasing across the internal resistance (109) of the sensor element (107, 207) is independent of these interference influences within a tolerance range.

4. The sensor arrangement (100, 200, 300) according to one of claims 1 to 3,
wherein the current regulator (101, 301) and the reference resistance (103) are implemented to execute the change of the feed current (12) such that with the interference influence-conditioned change of the reference resistance (103) and an accompanying interference influence-conditioned change of the internal resistance (109) of the sensor element (107, 207) the voltage (Vc) decreasing across the internal resistance (109) remains in a predetermined range.

5. The sensor arrangement (100, 200, 300) according to one of claims 1 to 4,
which is implemented to generate the voltage (Vc) decreasing across the internal resistance (109) of the sensor element (107, 207) such that the same counteracts an offset proportion in an output signal (VM) of the sensor arrangement (100, 200, 300).

6. The sensor arrangement (100, 200, 300) according to one of claims 1 to 5,
further comprising a temperature-stable reference voltage source (111) for generating the set voltage (Vsoll) and wherein the current regulator (101, 301) is implemented to regulate the reference current (I1) such that the voltage (VR) across the reference resistance (103) corresponds to the set voltage (Vsoll) within a predetermined tolerance range.

7. The sensor arrangement (300) according to one of claims 1 to 6,
wherein the current regulator (301) comprises a regulating amplifier (321) and a current provider (323, 325);
wherein the regulating amplifier (321) is implemented to provide a differential signal (Vctl1) which describes a deviation of the voltage (VR) decreasing across the reference resistance (103) from the set voltage (Vsoll); and wherein the current provider (323, 325) is implemented, based on the differential signal (Vctl1), to provide the reference current (I1) and the supply current (12) such that the supply current (I2) is proportional to the reference current (I1).

8. A sensor arrangement (400, 500), comprising:

a voltage regulator (401);
a feed current scaler (105, 505); and
a sensor element (107, 507) having an internal resistance (109, Rs);
wherein the voltage regulator (401) is implemented to set a supply voltage (Vssupply) for the sensor element (107, 507) and, in response to an interference influence-conditioned change of the internal resistance (109, Rs) of the sensor element (107, 507), to change a supply current (Isupply) of the sensor element (107, 507) such that the supply voltage (Vssupply) for the sensor element (107, 507) remains in a predetermined range;
wherein the voltage regulator (401) is further implemented to provide a feed current (12, Igm2) to the feed current scaler (105, 505) and to change this feed current (12, Igm2) depending on the change of the supply current (Isupply) for the sensor element (107, 507); and
wherein the feed current scaler (105, 505) is implemented, based on the feed current (12, Igm2), to supply a scaled feed current (Ic) into the sensor element (107, 507), to scale a voltage (Vc) decreasing across the internal resistance (109, Rs) of the sensor element (107, 507) according to the scaling of the feed current (I2, Igm2).

9. The sensor arrangement (400, 500) according to claim 8,
wherein the voltage regulator (401) is implemented to set the feed current (12) such that a change of the feed current (12) within a tolerance range is proportional to a change of the supply current (Isupply).

**10.** The sensor arrangement (500) according to one of claims 8 to 9,
wherein the voltage regulator (401) is a foot-point regulator (401) and is implemented to provide a foot-point voltage (Vfp) at the sensor element (507) to change, in response to the change of the internal resistance of the sensor element (507), the supply current (Isupply) of the same such that the foot-point voltage (Vfp) remains in a predetermined range and to set the feed current (12) proportional to the supply current (Isupply) within a tolerance range.

**11.** The sensor arrangement according to one of claims 8 to 9,
wherein the voltage regulator is a feeding regulator and is implemented to provide a sensor voltage at the sensor element to change, in response to the change of the internal resistance of the sensor element, the supply current of the same so that the sensor voltage remains in a predetermined range and to set the feed current proportional to the supply current within a tolerance range.

**12.** The sensor arrangement according to one of claims 1 to 11,
further comprising a scaling regulator (219);
wherein the scaling regulator (219) is implemented, based on an output signal (VM) of the sensor arrangement (500), to provide a scaling signal (Z, SIGN) to the feed current scaler (505);
wherein the feed current scaler (505) is implemented, based on the scaling signal (Z, SIGN), to provide the scaled feed current (Ic) so that the voltage (Vc) decreasing in the sensor element counteracts an offset proportion in the output signal (VM) of the sensor arrangement (500).

**13.** The sensor arrangement (500) according to one of claims 1 to 12,
which is implemented to impress the scaled feed current (Ic) at a terminal (507b, 507c) of the sensor element (507) into the sensor element (507) at which a sensor signal or at least a part of the sensor signal is provided by the sensor element (507) to reduce an offset existing in the sensor signal.

**14.** A method (600) in a sensor arrangement with a sensor element comprising an internal resistance, comprising:

providing (601) a reference current by a reference resistance;
providing (603) a feed current;
changing (605) the reference current in response to an interference influence-conditioned change of the internal resistance of the sensor element such that a voltage decreasing across the reference resistance remains in a predetermined range around an applied set voltage;
changing (607) a magnitude of the feed current depending on a magnitude of the reference current; and
feeding (609) a scaled feed current based on the feed current into the sensor element to scale a voltage decreasing across the internal resistance of the sensor element according to the scaling of the feed current;
wherein the reference resistance and the internal resistance comprise a predetermined ratio with respect to each other.

**15.** A method (700) in a sensor arrangement with a sensor element comprising an internal resistance, comprising:

setting (701) a supply voltage for the sensor element;
providing (703) a feed current;
changing (705) a supply current for the sensor element in response to an interference influence-conditioned change of the internal resistance of the sensor element so that the supply voltage for the sensor element remains within a predetermined range;
changing (707) the feed current depending on the change of the supply current for the sensor element; and
feeding (709) a scaled feed current based on the feed current into the sensor element to scale a voltage decreasing across the internal resistance of the sensor element according to the scaling of the feed current.

**Revendications**

**1.** Ensemble de capteurs (100, 200, 300), aux caractéristiques suivantes:

un régulateur de courant (101, 301);
une résistance de référence (103, Rref);

un modulateur de courant d'alimentation (105, 205); et

un élément capteur (107, 207) avec une résistance interne (109 Rs), où la résistance interne (109, Rs) de l'élément capteur (107, 207) et la résistance de référence (103, Rref) présentent un rapport prédéterminée entre eux;

dans lequel le régulateur de courant (101, 301) est réalisé pour mettre à disposition un courant de référence (I1, Iref) passant par la résistance de référence (103, Rref) et pour faire varier, en réponse à une variation de la résistance de référence due à des influences parasites, le courant de référence (I1, Iref) de sorte que la tension (VR) tombant en passant par la résistance de référence (103, Rref) reste dans une plage prédéterminée autour d'une tension de consigne appliquée (Vsoll);

dans lequel le régulateur de courant (101, 301) est par ailleurs réalisé pour mettre à disposition du modulateur de courant d'alimentation (105, 205) un courant d'alimentation (I2, Igm2) et pour faire varier une quantité du courant d'alimentation (I2, Igm2) en fonction d'une quantité du courant de référence (I1, Iref, Igm1); et

dans lequel le modulateur de courant d'alimentation (105, 205) est réalisé pour alimenter, sur base du courant d'alimentation (I2, Igm2), un courant d'alimentation modulé (Ic) dans l'élément capteur (107, 207) pour moduler une tension (Vc) tombant en passant par la résistance interne (109Rs) de l'élément capteur (107, 207) selon la modulation du courant d'alimentation (I2).

**2.** Ensemble de capteurs (100, 200, 300) selon la revendication 1,

dans lequel le régulateur de courant (101, 301) est réalisé pour faire varier la quantité du courant d'alimentation (I2) proportionnellement à la quantité du courant de référence (I1) selon un rapport qui résulte du rapport entre la résistance de référence (103) et la résistance interne (109) de l'élément capteur (107, 207) et d'un rapport entre la tension de consigne (Vsoll) et une tension (Vc) tombant, en cas de modulation inexistante ou minimale du courant d'alimentation (I2), en passant par la résistance interne (109).

**3.** Ensemble de capteurs (100, 200, 300) selon la revendication 1 ou 2,

dans lequel la résistance de référence (103) est réalisée de sorte que certaines influences parasites provoquant des variations de la résistance interne (109) de l'élément capteur (107, 207) font varier, selon un rapport correspondant, la grandeur de la résistance de référence (103) de sorte que la tension (Vc) tombant en passant par la résistance interne (109) de l'élément capteur (107, 207) se situe dans une plage de tolérance indépendante de ces influences parasites.

**4.** Ensemble de capteurs (100, 200, 300) selon l'une des revendications 1 à 3,

dans lequel le régulateur de courant (101, 301) et la résistance de référence (103) sont réalisés pour effectuer la variation du courant d'alimentation (I2) de sorte que, en cas de variation de la résistance de référence (103) due à des influences parasites et d'une variation en parallèle de la résistance interne (109) de l'élément de capteur (107, 207) due à des influences parasites, la tension (Vc) tombant en passant par la résistance interne (109) reste dans une plage prédéterminée.

**5.** Ensemble de capteurs (100, 200, 300) selon l'une des revendications 1 à 4,

qui est réalisé pour générer la tension (Vc) tombant en passant par la résistance interne (109) de l'élément capteur (107, 207) de sorte qu'elle contrecarre une part de décalage dans un signal de sortie (VM) de l'ensemble de capteurs (100, 200, 300).

**6.** Ensemble de capteurs (100, 200, 300) selon l'une des revendications 1 à 5,

présentant par ailleurs une source de tension de référence stable en température (111) destinée à générer la tension de consigne (Vsoll), et où le régulateur de courant (101, 301) est réalisé pour réguler le courant de référence (I1) de sorte que la tension (VR) à la résistance de référence (103) corresponde, dans une plage de tolérances prédéterminée, à la tension consigne (Vsoll).

**7.** Ensemble de capteurs (300) selon l'une des revendications 1 à 6,

dans lequel le régulateur de courant (301) présente un amplificateur de régulation (321) et un fournisseur de courant (323, 325);

dans lequel l'amplificateur de régulation (321) est réalisé pour mettre à disposition un signal de différence (Vctl1) qui décrit une déviation de la tension (VR) tombant en passant par la résistance de référence (103) par rapport à la tension de consigne (Vsoll); et

dans lequel le fournisseur de courant (323, 325) est réalisé pour mettre à disposition, sur base du signal de différence (Vctl1), le courant de référence (I1) et le courant d'alimentation (I2) de sorte que le courant d'alimentation (I2) soit proportionnel au courant de référence (I1).

**8.** Ensemble de capteurs (400, 500), aux caractéristiques suivantes:

un régulateur de tension (401);
un modulateur de courant d'alimentation (105, 505); et
un élément capteur (107, 507) avec une résistance interne (109, Rs);
dans lequel le régulateur de tension (401) est réalisé pour régler une tension d'alimentation (Vssupply) pour l'élément capteur (107, 507) et pour faire varier, en réponse à une variation de la résistance interne (109, Rs) de l'élément capteur (107, 507) due à des influences parasites, un courant d'alimentation (Isupply) de l'élément capteur (107, 507) de sorte que la tension d'alimentation (Vssupply) pour l'élément capteur (107, 507) reste dans une plage prédéterminée;
dans lequel le régulateur de tension (401) est par ailleurs réalisé pour mettre à disposition du modulateur de courant d'alimentation (105, 505) un courant d'alimentation (I2, Igm2) et pour faire varier ce courant d'alimentation (I2, Igm2) en fonction de la variation du courant d'alimentation (Isupply) pour l'élément capteur (107, 507); et
dans lequel le modulateur de courant d'alimentation (105, 505) est réalisé pour alimenter, sur base du courant d'alimentation (I2, Igm2), un courant d'alimentation modulé (Ic) vers l'élément capteur (107, 507) pour moduler une tension (Vc) tombant en passant par la résistance interne (109, RS) de l'élément capteur (107, 507) en fonction de la modulation du courant d'alimentation (I2, Igm2).

**9.** Ensemble de capteurs (400, 500) selon la revendication 8,
dans lequel le régulateur de tension (401) est réalisé pour régler le courant d'alimentation (I2) de sorte qu'une variation du courant d'alimentation (I2) dans une plage de tolérances soit proportionnelle à une variation du courant d'alimentation (Isupply).

**10.** Ensemble de capteurs (500) selon l'une des revendications 8 à 9,
dans lequel le régulateur de tension (401) est un contrôleur de base (401) et est réalisé pour mettre à disposition à l'élément capteur (507) une tension de base (Vfp) pour faire varier, en réponse à la variation de la résistance interne de l'élément capteur (507), son courant d'alimentation (Isupply) de sorte que la tension de base (VFP) reste dans une plage prédéterminée et pour régler, dans une plage de tolérance, le courant d'alimentation (I2) proportionnellement au courant d'alimentation (Isupply).

**11.** Ensemble de capteurs selon l'une des revendications 8 à 9,
dans lequel le régulateur de tension est un régulateur d'alimentation et est réalisé pour mettre à disposition de l'élément capteur une tension de capteur pour faire varier, en réponse à la variation de la résistance interne de l'élément capteur, le courant d'alimentation de ce dernier de sorte que la tension de capteur reste dans une plage prédéterminée et pour régler, dans une plage de tolérances, le courant d'alimentation proportionnellement au courant d'alimentation.

**12.** Ensemble de capteurs (500) selon l'une des revendications 1 à 11,
présentant par ailleurs un régulateur de modulation (219);
dans lequel le régulateur de modulation (219) est réalisé pour mettre à disposition du modulateur de courant d'alimentation (505), sur base d'un signal de sortie (VM) de l'ensemble de capteurs (500), un signal de modulation (Z, SIGN);
dans lequel le modulateur de courant d'alimentation (505) est réalisé pour mettre à disposition, sur base du signal de modulation (Z, SIGN), le courant d'alimentation modulé (Ic) de sorte que la tension (Vc) tombant dans l'élément capteur contrecarre une part de décalage dans le signal de sortie (VM) de l'ensemble de capteurs (500).

**13.** Ensemble de capteurs (500) selon l'une des revendications 1 à 12,
qui est réalisé pour imprimer le courant d'alimentation modulé (Ic) à une connexion (507b, 507c) de l'élément capteur (507) dans l'élément capteur (507) à laquelle est également mis à disposition par l'élément capteur (507) un signal de capteur ou au moins une partie du signal de capteur, pour réduire un décalage existant dans le signal de capteur.

**14.** Procédé (600) dans un ensemble de capteurs avec un élément capteur présentant une résistance interne, aux étapes suivantes consistant à:

mettre à disposition (601) un courant de référence passant par une résistance de référence;
mettre à disposition (603) un courant d'alimentation;
faire varier (605) le courant de référence, en réponse à une variation de la résistance interne de l'élément capteur due aux influences parasites, de sorte qu'une tension tombant en passant par la résistance de référence reste dans une plage prédéterminée autour d'une tension de consigne appliquée;

faire varier (607) une quantité du courant d'alimentation en fonction d'une quantité du courant de référence; et alimenter (609) vers l'élément capteur un courant d'alimentation modulé basé sur le courant d'alimentation, pour moduler une tension tombant en passant par la résistance interne de l'élément capteur selon la modulation du courant d'alimentation;

dans lequel la résistance de référence et la résistance interne présentent un rapport prédéterminé entre eux.

15. Procédé (700) dans un ensemble de capteurs avec un élément capteur présentant une résistance interne, aux étapes suivantes consistant à:

régler (701) une tension d'alimentation pour l'élément capteur;

mettre à disposition (703) un courant d'alimentation;

faire varier (705) un courant d'alimentation pour l'élément capteur, en réponse à une variation de la résistance interne de l'élément capteur due à des influences parasites de sorte que la tension d'alimentation pour l'élément capteur reste dans une plage prédéterminée;

faire varier (707) le courant d'alimentation en fonction de la variation du courant d'alimentation pour l'élément capteur; et

alimenter (709) vers l'élément capteur un courant d'alimentation modulé basé sur le courant d'alimentation, pour moduler une tension tombant en passant par la résistance interne de l'élément capteur selon la modulation du courant d'alimentation.

FIG 1

FIG 2

FIG 3

FIG 4

FIG 5

600

601

Bereitstellen eines Referenzstroms durch einen Referenzwiderstand.

603

Bereitstellen eines Einspeisestroms.

605

Veränderung des Referenzstroms, ansprechend auf eine störeinflussbedingte Änderung des Innenwiderstands des Sensorelements derart, dass eine über den Referenzwiderstand abfallende Spannung in einem vorgegebenen Bereich um eine angelegte Sollspannung bleibt.

607

Veränderung eines Betrags des Einspeisestroms in Abhängigkeit von einem Betrag des Referenzstroms.

609

Einspeisen eines auf dem Einspeisestrom basierenden skalierten Einspeisestroms in das Sensorelement, um eine über den Innenwiderstand des Sensorelements abfallende Spannung entsprechend der Skalierung des Einspeisestroms zu skalieren.

## FIG 6

701

700

| Einstellen einer Speisespannung für das Sensorelement. |

703

| Bereitstellen eines Einspeisestroms. |

705

| Veränderung eines Speisestroms für das Sensorelement, ansprechend auf eine störeinflussbedingte Veränderung des Innenwiderstands des Sensorelements, so dass die Speisespannung für das Sensorelement in einem vorgegebenen Bereich bleibt. |

707

| Verändern des Einspeisestroms in Abhängigkeit der Veränderung des Speisestroms für das Sensorelement. |

709

| Einspeisen eines auf dem Einspeisestrom basierenden skalierten Einspeisestroms in das Sensorelement, um eine über den Innenwiderstand des Sensorelements abfallende Spannung entsprechend der Skalierung des Einspeisestroms zu skalieren. |

## FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004010362 B4
- DE 102009006546 A1
- US 20030178989 A1
- EP 0525235 A
- EP 0464391 A1